(19) Europäisches Patentamt
European Patent Office
Office européen des brevets

(11) **EP 1 746 469 A1**

(12) **EUROPEAN PATENT APPLICATION**
published in accordance with Art. 158(3) EPC


(43) Date of publication:
**24.01.2007 Bulletin 2007/04**

(21) Application number: **05737353.2**

(22) Date of filing: **27.04.2005**

(51) Int Cl.:
***G03H 1/02*** *(2006.01)* ***G03H 1/04*** *(2006.01)*
***G11B 7/0065*** *(2006.01)*

(86) International application number:
**PCT/JP2005/008052**

(87) International publication number:
**WO 2005/109114 (17.11.2005 Gazette 2005/46)**

(84) Designated Contracting States:
**DE DK FR GB HU SE**

(30) Priority: **10.05.2004 JP 2004139489**



(71) Applicant: **Konica Minolta Medical & Graphic, Inc.**
**Tokyo 163-0512 (JP)**

(72) Inventor: **TAKEYAMA, Toshihisa,**
**Konica Minolta M. & G., Inc.**
**Hino-shi, Tokyo 1918511 (JP)**

(74) Representative: **Gille Hrabal Struck Neidlein Prop Roos**
**Patentanwälte**
**Brucknerstrasse 20**
**40593 Düsseldorf (DE)**


(54) **HOLOGRAPHIC RECORDING MEDIUM, HOLOGRAPHIC RECORDING METHOD, AND HOLOGRAPHIC INFORMATION MEDIUM**


(57) A holographic recording medium including: an anti-reflection layer; an first substrate; a holographic recording layer containing a binder forming compound, a photopolymerizable compound which has a functional group being capable of photopolymerization and a photopolymerization initiator which can initiate a polymerization reaction of the photopolymerizable compound; and a second substrate, in that order, wherein at least one of the first substrate and the second substrate is a plastic substrate having a light transmittance of more than 90% measured according to ASTM D1003 at a thickness of 3 mm.


FIG. 1 (a)

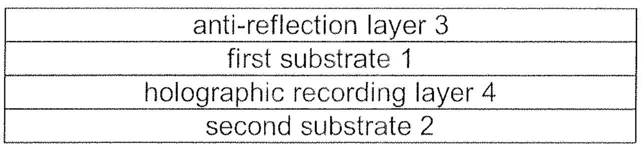


EP 1 746 469 A1

FIG. 1 ( b )

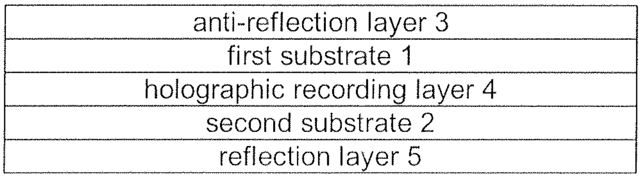
anti-reflection layer 3
first substrate 1
holographic recording layer 4
second substrate 2
reflection layer 5

FIG. 1 ( c )

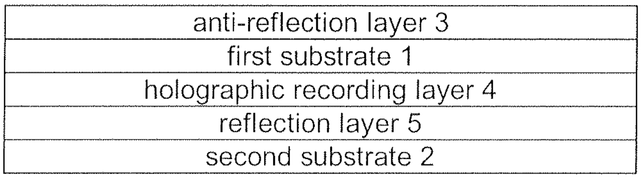
anti-reflection layer 3
first substrate 1
holographic recording layer 4
reflection layer 5
second substrate 2

## Description

### TECHNICAL FIELD

The present invention relates to a holographic recording medium that can be of a large capacity and can make high speed transfer possible, and further to a holographic recording method and to a holographic information medium on which information is recorded holographically.

### BACKGROUND ART

In recent years, high-speed exchanges of data in a large volume have been increased by the spread of Internet and by a shift to the broadband system, and a volume of data stored in each affiliated organ has been expanded rapidly because of extension of e-governments caused by promotion of the government of each country. In addition, recording media each having high storage capacity are expected to be needed in the future, by the spread of a high-definition television in a TV broadcast and by the spread of a digital terrestrial broadcast, and among them, next-generation optical recording media such as a blu-ray disc and a HDDVD disc are estimated to spread in the future. With respect to the next but one generation recording media, however, main products are absent, although various systems are proposed.
Among the next but one generation recording media, a memory system of a page type, especially, holographic recording is proposed to take the place of a conventional memory device, and it is watched with keen interest recently, because it has a high storage capacity and is of the system which makes random access and high speed transfer possible. With respect to this holographic recording, detailed explanations are described in some introductions (such as, for example, Non Patent Document 1).
As a recording system in the holographic recording, a recording method using a holographic recording medium wherein transparent materials are arranged respectively on both sides of a holographic recording layer (for example, Patent Document 1) and a recording method using a holographic recording medium equipped with a reflection surface arranged on one side of a holographic recording layer (for example, Patent Document 2) are proposed.
In the basic principle of the holographic recording medium of this kind, the refractive index in a holographic recording layer in the medium is changed to record information by giving holographic exposure, and the change of the refractive index recorded in the medium is read to regenerate information, and there are proposed various materials as a material for the holographic recording layer, including the material using an inorganic material (for example, Patent Document 3), the material using a compound that shows structural isomer with light (for example, Patent Document 4), or the material using diffusion polymerization of photopolymer (for example, Patent Document 5). Among these, in the material using photopolymer described in Patent Document 5, a volatile solvent is used in the case of manufacturing a composition for forming a recording layer, and therefore, the maximum thickness of the recording layer is limited to about 150 μm. In addition, volume shrinkage of 4 - 10% caused by polymerization has affected adversely the reliability in the case of regenerating recorded information.
There are proposed a composition for forming a holographic recording layer utilizing cation polymerization wherein no solvent is used and organization shrinkage is relatively less (for example, Patent Document 6) and others, for improving the aforesaid weak points. However, the composition for forming a holographic recording layer has drawbacks wherein there is a fear that island-shaped portions formed, under the holographic exposure, by photopolymerization of monomer in the recording layer are moved undesirably, and a volume of liquid substance is expanded by changes of ambient temperatures in the apparatus, because those other than monomer that causes photo-cation polymerization are liquid substances.
To improve these drawbacks, radical polymerization is used for recording in holographic exposure, and there is proposed a composition (for example, Patent Document 7) that forms a binder after forming a medium, for holding monomer that makes this radical polymerization before exposure to be possible, thus, it is possible to thicken a layer thickness of the holographic recording layer and to lessen the volume shrinkage by using the composition of this kind.
On the other hand, when the mass of a holographic recording medium itself is taken into consideration, it is desirable to make a substrate as light as possible, and an example using a resin substrate (for example, Patent documents 8, 9) as the substrate is proposed. However, in these substrates, since there may be a case that a light exposure energy of an information light or a reproduction light may be required due to a lower of light quantity caused by reflection on a substrate interface, when a non-recorded thing was stored, there was a case where sensitiveness fell depending on a holographic recording layer.

[Non Patent Document 1] "Holographic Data Storage (Springer Series in Optical Sciences, Vol. 76)" written by Hans J. Coufal and others (Springer-Verlag GmbH & Co. KG, August in 2000)
[Patent Document 1] U. S. Patent No.5,719,691
[Patent Document 2] TOKKAI No. 2002-123949

[Patent Document 3] British Patent No. 9,929,953
[Patent Document 4] TOKKAIHEI No. 10-340479
[Patent Document 5] U. S. Patent No. 4,942,112
[Patent Document 6] U. S. Patent No. 5,759,721
[Patent Document 7] U. S. Patent No. 6,103,454
[Patent Document 8] U. S. Patent No. 6,348,983
[Patent Document 9] U. S. Patent No. 6,611,365

## DISCLOSURE OF THE INVENTION

## PROBLEM TO BE SOLVED BY THE INVENTION

This invention has been made in view of the above problems. An objective of this invention is to provide a holographic recording medium and a holographically recorded holographic information medium on which information is recorded holographically, which have low mechanical loads, high-sensitivity and high-storage stability, and a holographic recording method for preparing the holographic recording medium and the holographic information medium.

## MEANS FOR SOLVING THE PROBLEM

The above object can be attained by the following structures.
A holographic recording medium including:

an anti-reflection layer;
an first substrate;
a holographic recording layer containing a binder forming compound, a photopolymerizable compound which has a functional group being capable of photopolymerization and a photopolymerization initiator which can initiate a polymerization reaction of the photopolymerizable compound; and
a second substrate, in that order,
wherein at least one of the first substrate and the second substrate is a plastic substrate having a light transmittance of more than 90 % measured according to ASTM D1003 at a thickness of 3 mm.

A holographic recording method for recording information on the above holographic recording medium, comprising :

reacting the binder forming compound for forming a binder;
holographic exposing a surface of the anti-reflection layer of the holographic recording medium based on the information for generating activated species by activating the photopolymerization initiator; and
diffusion polymerizing the photopolymerizable compound by the activated species in the holographic recording layer.

A holographic information medium comprising:

an anti-reflection layer;
an first substrate;
a holographic information recording layer containing a binder area containing the binder as major component formed by reacting a binder forming compound and a photopolymerized area containing a photopolymerized compound a major component formed by photopolymerizing a compound which has a functional group being capable of photopolymerization, and a refractive index of the binder area is lower than a refractive index of the photopolymerized area; and
a second substrate, in that order,
wherein at least one of the first substrate and the second substrate is a plastic substrate having a light transmittance of more than 90% measured according to ASTM D1003 at a thickness of 3 mm.

## [EFFECT OF THE INVENTION]

Owing to the invention, it has become possible to obtain a holographic recording medium and a holographically recorded holographic information medium on which information is recorded holographically, which have low mechanical loads, high-sensitivity and high-storage stability, and a holographic recording method for preparing the holographic recording medium and the holographic information medium.

**[BRIEF DESCRIPTION OF THE DRAWINGS]**

Fig. 1 is a sectional view explaining a layer construction of a holographic recording medium and a holographic information medium.

1 first substrate

2 second substrate

3 reflection prevention layer

4 a holographic recording medium or a holographic information medium

5 reflection layer

**[BEST MODE FOR CARRYING OUT THE INVENTION]**

Hereinafter, a holographic recording medium, a holographic recording method, and a holographic information medium will be explained.

In the following, the construction of layers included in the holographic recording medium and the holographic information medium will be explained, using the Fig. 1(a), Fig. 1(b) and Fig 1(c).

The Fig. 1(a), Fig. 1(b) and Fig 1(c) are the sectional views showing the construction of layers included in the holographic recording medium and the holographic information medium.

As showing in the Fig. 1(a), Fig. 1(b) and Fig 1, the holographic recording medium and the holographic information medium of this invention have the basically construction having a holographic recording layer (or a holographic information recording layer) 4 is sandwiched between the first substrate 1 and the second substrate 2, wherein the anti-reflection layer 3 is provided on the first substrate 1.

Furthermore, it is possible to provide a reflection layer 5 on the second substrate 2 as shown in Fig. 1(b). The reflection layer can be also provided between the holographic recording layer (or a holographic information recording layer) 4 and the second substrate 2 as shown in the Fig. 1(c).

In the following, the holographic recording medium and the holographic information medium will be detailed.

The invention is characterized that a holographic recording medium includes: an anti-reflection layer; an first substrate; a holographic recording layer containing a binder forming compound, a photopolymerizable compound which has a functional group being capable of photopolymerization and a photopolymerization initiator which can initiate a polymerization reaction of the photopolymerizable compound; and a second substrate, in that order, wherein at least one of the first substrate and the second substrate is a plastic substrate having a light transmittance of more than 90% measured according to ASTM D1003 at a thickness of 3 mm.

The character described above is able to make the holographic recording medium and the holographic information medium be lighter and to prevent from not only reducing the sensitivity caused by reflection but also permeation of water or oxygen acting as an inhibitory agent for diffusing polymerization of the photopolymerizable compound which has a functional group being capable of photopolymerization in the a holographic recording layer.

Next, the plastics substrate used for at least one of the first substrate and the second substrate is described.

Resin used for the plastics substrate according to the present invention can be used without a special restriction, when the light transmittance is more than 90 % measured according to ASTM D1003 at a thickness of 3 mm. Polymethylmethacrylate and bisphenol A type polycarbonate can be cited as such resin. In the present invention, at least one of the following sort is particularly preferable for preventing from a deformation of the mechanical strength mentioned later, a deformation of the media at the case of production, a deterioration of recording sensitivity, or error rate reduction: resin which has a cyclic olefin as a monomeric unit, resin which has 1,1 - bis (four hydroxyphenyls) cyclohexane as a monomeric unit, resin which has 1,1 bis (4- hydroxyphenyl) -3,3,5- trimethyl cyclohexane as a monomeric unit, and resin represented with the below general formula (1). Besides, although this light transmittance does not become 100%, it is desirable for this total light transmittance to be high as much as possible. general formula (1).

Formula (1)

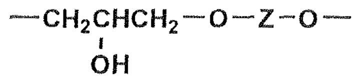

(In the general formula (1), Z represents a divalent linkage group.)

As resin which has a cyclic olefin as a monomeric unit, resin described by each following official gazette etc., for example can be chosen suitably, and can be used.

JP-A No. 5-25220, No. 5-247324, No. 5-279554, No. 6-80864, No. 6-107735, No. 6-107736, No. 6-136035, No. 6-136057, No. 7-41550, No. 7-62068, No. 7-324108, No. 9-263627, No. 10-152549, JP-A No. 2000-219725, No. 2000-212226, No. 5-140232, No. 6-128557, No. 6-228234, No. 8-109222, No. 10-245420, No. 5-97978, No. 6-206985, No. 6-279656, No. 7-62028, No. 7-173085, No. 7-179730, No. 7-228673, No. 9-221577, No. 9-296028, No. 9-316179, No. 9-324082, No. 9-326512.

Moreover, in these kinds of resin, resin marketed by the product name of ZEONOR (products made by Nippon Zeon Co., Ltd.), Aton (product made from JSR), Appel (product made from Mitsui Chemicals), etc. can be obtained easily, and these kind of marketed resin can be suitably chosen and used.

The examples of such a resin provided with 1,1- bis (4-hydroxyphenyl) cyclohexane as a monomeric unit include such as an ester polymer obtained by the direct polymerization of 1,1-bis (4- hydroxyphenyl) cyclohexane and a polycarbonate multivalent carboxylic acid compound and a polycarbonate including 1,1- bis (4- hydroxyphenyl) cyclohexane as a monomeric unit as a bisphenol component.

The examples of such a resin provided with 1,1 bis (4-hydroxyphenyl) -3,3,5- trimethyl cyclohexane as a monomeric unit include such as an ester polymer obtained by the direct polymerization of 1,1 - bis (4- hydroxyphenyl)-3, 3, 5-trimethyl cyclohexane and a multivalent carboxylic acid compound, and the polycarbonate including 1,1- bis (4-hydroxyphenyl) -3,3,5- trimethyl cyclohexane as a monomeric unit as a bisphenol component.

Furthermore, within the limits of the present invention, the copoly carbonate described by JP-A No. 2-88638 etc. can also be chosen timely, and can be used.

Moreover, resin which has the structural unit of the above-mentioned general formula (1) can be obtained by carrying out the condensation reaction of the compound which have two hydroxyl groups and epichlorohydrin, and if it is the compound which has two hydroxyl groups being possible to react of a condensation reaction with the epichlorohydrin which become the structural unit of the scope of the present invention, it can be particularly used without a restriction.

For example, Diol, such as 1, 4-dihydroxy cyclohexane, 1 , 4-dihydroxy naphthalene, 1, 5-dihydroxy naphthalene, 4, and 4'-dihydroxy biphenyl and 2,2'-bis (4-hydroxy cyclohexyl) propane, can be cited.

Furthermore, Z in the structural unit of the above general formula (1) represents a divalent connecting group.

The structure represented in a following general formula (2) can suppress the deformation at the time of using as a base material, since the glass transition temperature at the time of using it as binder resin is high. Z represented in a general formula (2) can cite the following structure, for example. However, when it is the structure of the scope of the present invention, it will not be limited in particular to these.

Formula (2)

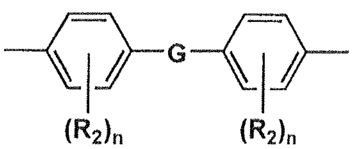

In Formula (2), G represents -O-, -S-, -SO-, $-SO_2-$, -CO- and linkage group of carbon chain, $R_2$ a represents substituent including hydrogen, alkyl group, alkoxy group, halogen and n represents 0, 1, 2, 3, or 4.

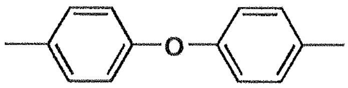
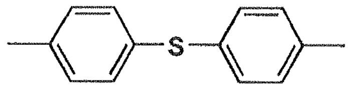

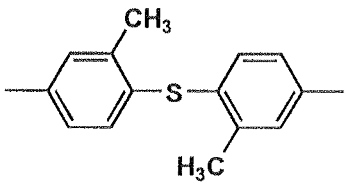
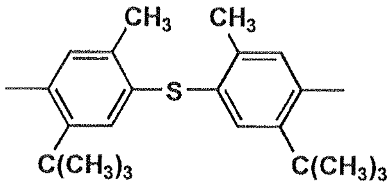

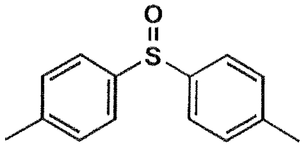
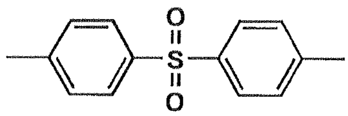

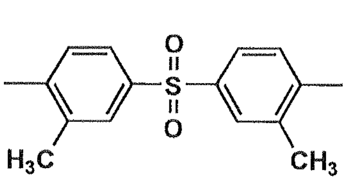
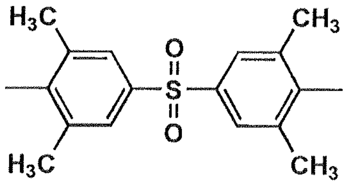

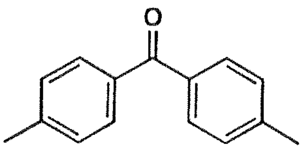
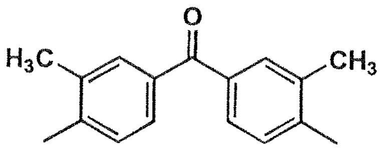

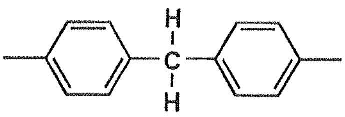
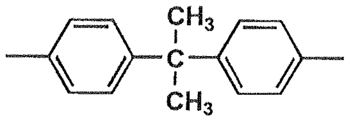

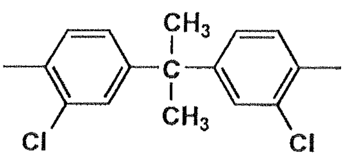
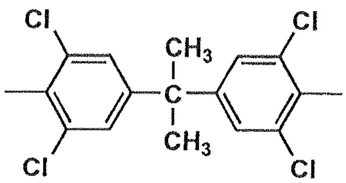

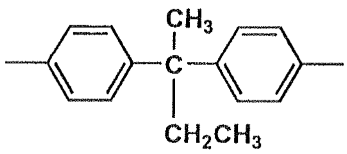

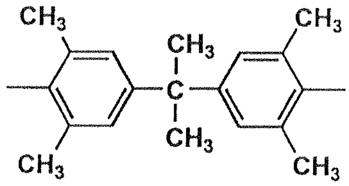

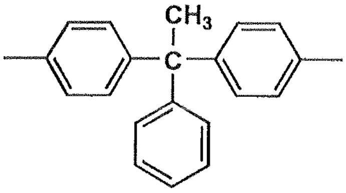

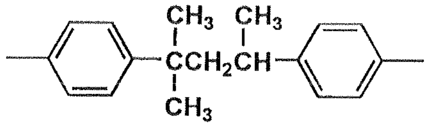

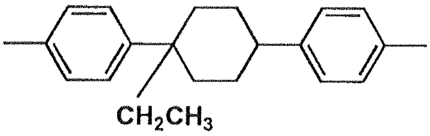

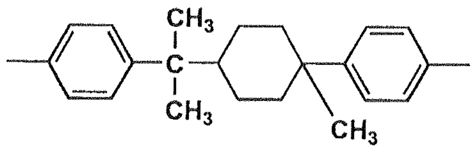

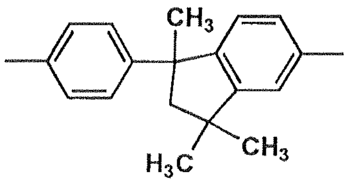

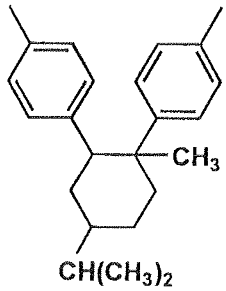

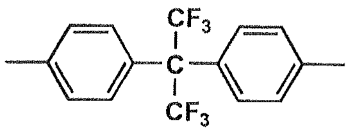

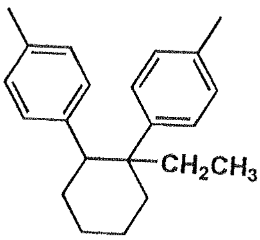

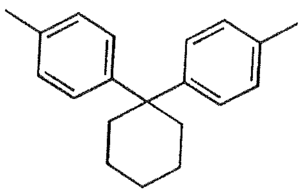

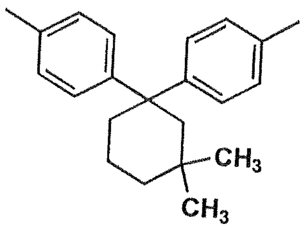

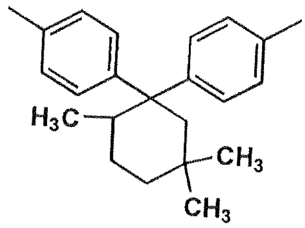

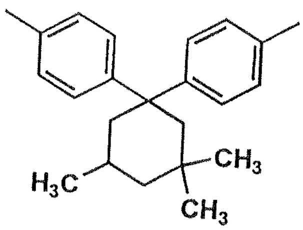

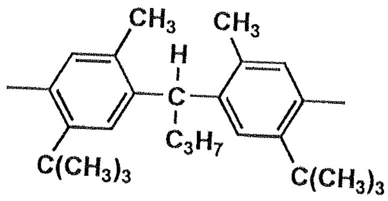

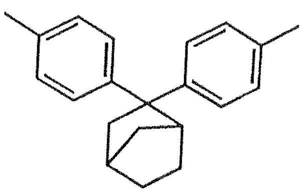

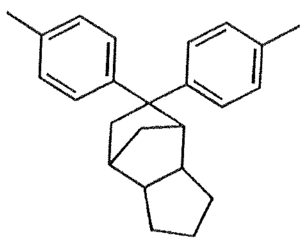

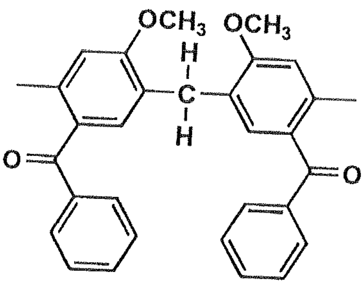

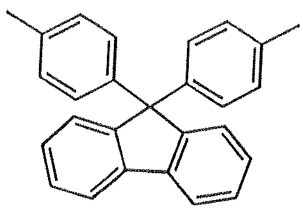

Furthermore, the resin represented by Formula (1) can cite the following structure, for example.

B−1

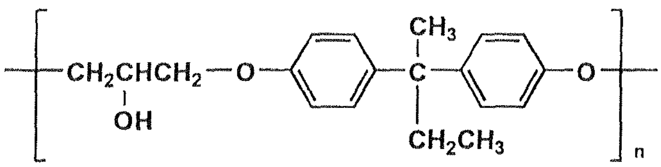

Tg 95°C

B−2

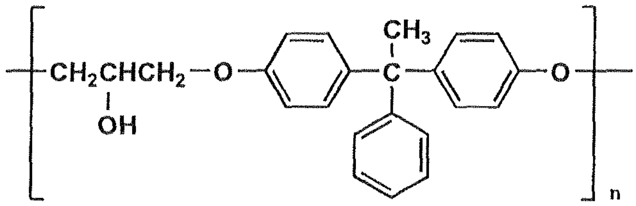

Tg 115℃

B−3

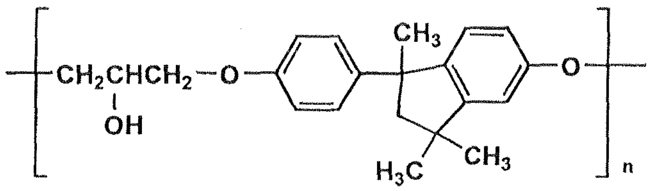

Tg 120℃

B−4

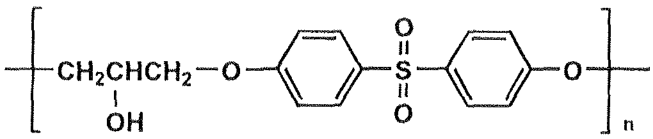

Tg 165℃

B−5

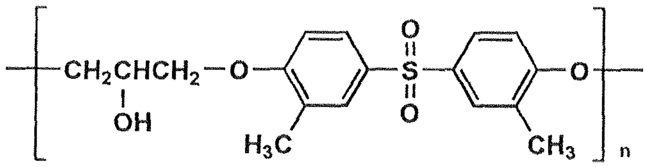

Tg 135℃

B−6

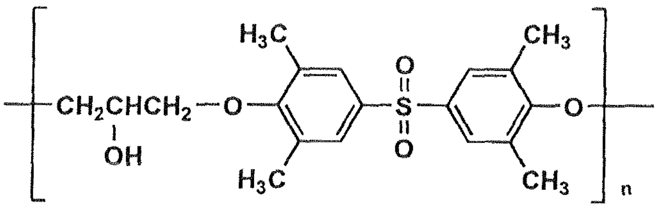

Tg 145℃

B－7

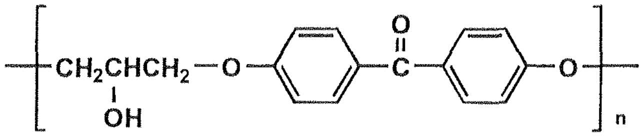

Tg 130℃

B－8

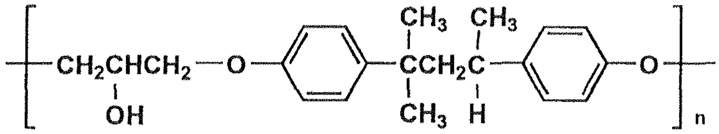

Tg 75℃

B－9

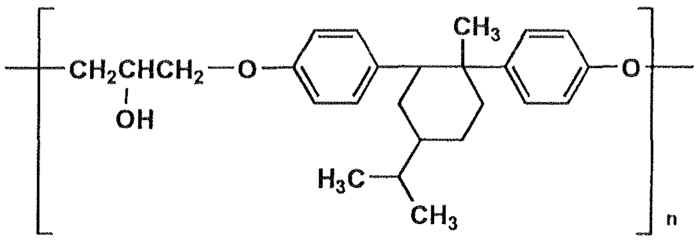

Tg 175℃

B－10

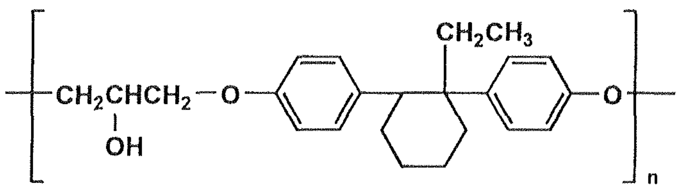

Tg 140℃

B－11

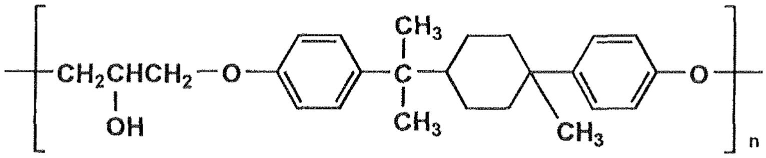

Tg 135℃

B−12

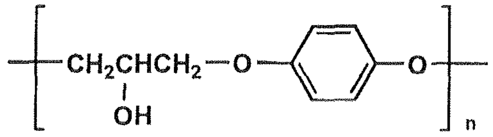

Tg 60°C

Furthermore, as resin used for the base material according to the present invention from a viewpoint of the bridge construction requirements for forming a binder from the binder formation compound explained below and of the mechanical strength or the after-mentioned, it is preferable to make glass transition temperature into 100 degrees Celsius or more and 250 degrees Celsius or less. Furthermore, when glass transition temperature is lower than 100 degrees Celsius, it is not preferable, since it may be transformed depending on the bridge construction requirements for forming a binder.

Moreover, when glass transition temperature is larger than 250 degrees Celsius, it is not preferable since the fluxing and kneading requirements of resin in the case of molding a base material by a method such as injection become severe, or mold temperature and cylinder temperature become high temperature and molding conditions become severe. Moreover, when the functional group of the compound including at least one functional group which is contained in a holographic recording layer, and which can be photopolymerized is a radical polymerizable group (for example, in case of a functional group like the acyloyl group or the methacryloyl group which have an unsaturation double bond), it is more preferable that the oxygen permeability specified by ASTM D3985 of resin which forms the plastics substrate mentioned above is below 1000cm3·mm/(m2·24hr·MPa) in order to suppress sensitivity lowering more. Resin which has a cyclic olefin as a monomeric unit as such resin is more preferable particularly. Furthermore, as a lower limit of this oxygen permeability, it is $10cm^3$·mm/($m^2$·24hr·MPa).

On the other hand, when the binder forming compound contained in a holographic recording layer is formed by cationic polymerization, it is preferable that the water absorption specified by ASTM D570 of resin which forms the plastics substrate mentioned above is below 0.5% (23 degrees Celsius, one week), furthermore, it is more preferable that the water vapor transmission rate specified by ASTM F1249 is 0.20g/($m^2$·24hr) or below, in order not to make the polymerization reaction by moisture prevent or to prevent that prescribed binder physical properties being not acquired. Moreover, when the functional group of the compound which having at least one functional group which can be photopolymerized is a cation polymerizable group (for example, in case of a functional group which has the epoxy group which carries out ring opening polymerization by a cation, and an oxetane group), it is preferable that the water absorption specified by ASTM D570 of resin which forms the plastics substrate mentioned above is below 0.5% (23 degrees Celsius, one week), furthermore, it is more preferable that the water vapor transmission rate specified by ASTM F1249 is 0.20g/($m^2$·24hr) or below , in order to reduce changing the refractive index of a base substrate with the moisture contained in the base substrate or suppressing sensitivity lowering more, in other words, to reduce the rate which becomes an error according to the ambient left by medium at the time of reproduction.

Next, the anti-reflective layer on the first substrate where information light and reference light enter into the holographic recording medium will be explained in detail.

In order to raise the efficiency of the entering light, when an incident light enters from a perpendicular right angle using the same light source as an incident light, 2% or less has preferable reflectance. It is more preferable to prepare so that it may become 1 more% or less. When a refractive index is lower than the refractive index of the first base material, there is no restriction particularly for an antireflection layer, it is more preferable of using the inorganic metal fluoride including AlF3, MgF2, AlF3, MgF2 and CaF2, the homopolymer containing fluorine atoms which includes vinylidene fluoride and a teflon (registered trademark), the copolymer, the graft polymer, the block polymer, organic fluorides such as a denaturation polymer embellished by the functional group that contains a fluorine atom, and SiO2 since the refractive index becomes lower.

Herein, a method to provide a layer comprising a fluorine type compound on a substrate cannot be ununequivocally defined depending on types of a substrate or a fluorine type compound, however, commonly known methods such as a sol-gel method, a vacuum evaporation method, a sputtering method, a DVD method or a coating method, or methods described in JP-A Nos. 7-27902, 2001-123264 and 2001-264509 by suitable selection.

Furthermore, the multilayered antireflection film which laminated two or more low-refractive-index layers used for acid resisting, such as a plastic lens and a light element, and high refractive index layers can also be conveniently used by the present invention. As such a multilayered antireflection film, lamination or method described in each official gazette of JP-A No. 5-142401, No. 5-249303, No. 6-3504, No. 6-331803, No. 7-35902, No. 7-253501, and No. 11-311702 etc. can be suitably chosen and used.

The thickness of such an anti-reflection layer is not ununequivocally defined depending on a surface treatment

or materials of a substrate, however, it is generally in a range of 0.001 - 20 μm and preferably in a range of 0.005 - 10 μm.

Moreover, when a light enters from the first substrate side and information reading is performed from the second substrate side to a holographic recording medium and holographic information medium which are used for United. States Patent No. 5, 838, 467, and holographic recording and the regenerative apparatus of each specification of No. 6,700,686, the single layer antireflection film or the multilayer antireflection layer may further be arranged on the surface of second substrate provided on the holographic recording layer, in other words, to side with the detective section for detecting a light.

Besides, it is preferable that reflective layer which has reflectance of 80% or more is provided on at least one of the surface of the second substrate facing to the holographic recording layer or another surface of second substrate. Thus, when providing a reflective layer, it is preferable to make reflectance 80% or more to the wavelength of a light to reflect, and it is more preferable to make it to 85 more% or more.

The materials of such a reflection layer are not specifically limited provided that a desired reflectance is obtained, however, the layer can be generally accumulated by providing a thin layer comprising such as a metal on the substrate surface. To form such an reflection layer, a metal single crystal or polycrystal can be accumulated as a metal thin layer by a commonly known method such as a vacuum evaporation method, an ion plating method or a sputtering method, and as metals utilized to accumulate a metal thin layer, utilized can be alone or in combination of two or more types of metals such as aluminum, zinc, antimony, indium, selenium, tin, tantalum, chromium, lead, gold, silver, platinum, nickel, niobium, germanium, silicon, molybdenum, manganese, tungsten and palladium. The thickness of the metal thin layer is not limited provided that a desired reflectance can be obtained, however, is generally in a range of 1 - 3000 nm and preferably in a range of 5 - 2000 nm. Further, in a holographic recording medium of this invention, physical patterns may be formed on one side surface of either substrate to track the position of information to be recorded or recorded information in the medium, similarly to commonly known optical disks such as a CD and a DVD, and as such patterns and methods to form the same, utilized by suitable selection can be those described, for example, in JP-A Nos. 2003-178456, 2003-228875, 2003-331464, 2004-126038, 2004-126040, 2004-126041 and 2004-127379, USP No. 6,625,100, US Patent Publication Open to Public Inspection Nos. 2004/0042375 and 2004/0067419.

In an above-mentioned holographic recording media, if at least one of the first substrate and the second substrate is the plastics described above, a mass can be reduced to the holographic recording media which constructed glasses in both sides. Furthermore, as a glass substrate which can be used as substrate other than a plastics substrate, it combines with a plastics substrate, and glasses, such as quarts glass, soda glass, potash glass, lead crystal glass, boro silicate glass, almino silicate glass, titanium crystal glass, or glass ceramics, etc. can be chosen suitably, and can be used, for example.

However, to reduce the load produced by rotation of holographic recoding or playing, it is preferable of reducing the mass of the holographic recording media and information media, and to deduce the mass thereof it is preferable that both of the first substrate and second substrate is plastic substrate.

On the other hand, in a holographic recording medium, it is possible to prepare a recording medium having a high memory capacity by making a holographic recording layer as thick as possible, however, it is preferable to satisfy the relationship of $0.15 \leq Dh/(D1 + D2) \leq 2.0$, when the thickness of the first substrate is D1, the thickness of the second substrate is D2 and the thickness of a holographic recording layer is Dh, in view of the using environment of said recording medium and reading error of recorded information.

Herein, a layer thickness of a holographic recording layer cannot be made thicker when $0.15 > Dh/(D1 + D2)$, or the whole recording medium may become thick because the thickness of a substrate become thick even when the thickness of a recording layer is made thicker. This case is not preferred because an excess load may be generated due to the heavy weight of the recording medium itself. While, the thickness of a recording medium can be made thin while keeping the thickness of a recording layer when $Dh/(D1 + D2) > 2.0$, however, it is not preferred because the thickness of a recording layer becomes thick compared to the thickness of a substrate resulting in deteriorated plane precision of a recording medium, layer thickness unevenness of a recording layer at using environmental temperature, and layer thickness variation of a recording layer or a possible shift of the first substrate and the second substrate with an unexpected stress.

Further, the relationship between thickness D1 of the first substrate and thickness D2 of the second substrate is preferably $D1 \leq D2$, with respect to energy losses at the time of holographic exposure, and the thickness ratio of D1 to D2 is preferably in a range of $0.20 \leq D1/D2 \leq 1.00$ to secure the flatness of a recording medium.

Further, thickness Dh of a holographic recording layer is not unequivocal defined depending on a diffraction efficiency, a dynamic range and a special resolution of a recording layer, however is generally preferably not less than 200 μm and not more than 2.0 mm, and it is not preferable that a recording medium with a high memory capacity cannot be obtained when the thickness is less than 200 μm, while deteriorated plane precision of a recording medium and layer thickness unevenness of a recording layer at using environmental temperature may possibly result when the thickness is over 2.0 mm.

On the other hand, the shape of a recording medium is not specifically limited provided being suitable to a holographic recording·reproducing device utilized for said recording medium, however, a disk-form is preferred when it

is utilized in a device described in such as USP No. 5,719,691 and JP-A No. 2002-123949, and a card form is preferred when it is utilized in a device described in such as World Patent Publication No. 99/57719.

Next, holographic recording layer sandwiched between the first substrate and second substrate will be detailed.

The holographic recording layer included in the holographic recording media of the invention includes a binder forming compound, a photopolymerizable compound which has a functional group being capable of photopolymerization and a photopolymerization initiator which can initiate a polymerization reaction of the photopolymerizable compound.

A binder forming compound of this invention is characterized in that binder forming compounds each other do not polymerize or cross-link at the time of preparing a holographic recording composition but the binder forming compound is converted into a binder by polymerization or cross-linking at the time of preparing a holographic recording medium described below or after holographic exposure.

As such a binder forming compound, utilized can be at least one combination by appropriately selecting from (1) a compound provided with an isocyanate group and a compound provided with a hydroxyl group, (2) a compound provided with an isocyanate group and a compound provided with an amino group, (3) a compound provided with a carbodiimido group and a compound provided with a carboxyl group, (4) a compound provided with an unsaturated ester group and a compound provided with an amino group, (5) a compound provided with an unsaturated ester group and a compound provided with a mercaptan group, (6) a compound provided with a vinyl group and a compound provided with a silicon hydride group, (7) a compound provided with an oxirane group and a compound provided with a mercaptan group; (8) a compound provided with a group selected from oxirane, oxetane, tetrahydrofuran, oxepane, monocyclic actal, bicyclic acetal, lactone, cyclic orthoester and cyclic carbonato in the molecule and a thermal cationic polymerization initiator.

More preferably, a binder forming compound, utilized can be at least one combination by appropriately selecting from among above selection is at least one type selected from (1) a compound provided with an isocyanate group and (2) a compound provided with a hydroxyl group, or (3) a compound provided with an oxirane group and a compound provided with a mercaptan group, which can be polymerized or cross-linked to be a binder at a mild condition.

A compound (1) provided with an isocyanate group, which is employed at the time of cross-linking a compound provided with an isocyanate group and a compound provided with a hydroxyl group, is not specifically limited, however, more preferable is a compound provided with two or more isocyanate groups in the molecule with respect to sufficiently hold a compound provided with an ethylenic unsaturated bond as a photopolymerization composition detailed above after preparation of a holographic recording medium.

Specific examples of such a compound provided with an isocyanate group include such as 1,8-diisocyanate-4-isocyanatemethyl octane, 2-isocyanateethyl-2,6-diisocyanate caproate, benzene-1,3,5-triisocyanate, 1-methylbenzene-2,4,6-triisocyanate, 1,3,5-trimethylbenzene-2,4,6-triisocyanate, diphenylmethane-2,4,4'-triisocyanate, triphenylmethane-4,4',4"-triisocyanate, bis(isocyanatetolyl)phenylmethane, dimethylene disiocyanate, tetramethylene diisocyanate, hexamethylene diisocyanate, 2,2-dimethylpentane diisocyanate, 2,2,4-trimethylpentane diisocyanate, decane isocyanate, ω,ω'-disiocyanate-1,3-dimethylbenzene, ω,ω'-disiocyanate-1,2-dimethylcyclohexane diisocyanate, ω,ω'-disiocyanate-1,4-diethylbenzene, isophorone diisocyanate, 1-methylhexyl-2,4-diisocyanate, ω,ω'-disiocyanate-1,5-dimethylnaphthalene, ω,ω'-disiocyanate-n-propylbiphenyl, 1,3-phenylene diisocyanate, 1-methylbenzene-2,4-diisocyanate, 1,3-dimethylbenzene-2,6-diisocyanate, naphthalene-1,4-diisocyanate, 1,1-dinaphthyl-2,2'-diisosianate, biphenyl-2,4-diisocyanate, 3,3'-di-methylbiphenyl-4,4'-diisocyanate, diphenylmethane-4,4'-diisocyanate, 2,2'-dimethyldiphenylmethane-4,4'diisocyanate, dicyclohexylmethane-4,4'-diisocyanate, 3,3'-dimethoxydiphenylmethane-4,4'-diisocyanate, 4,4'-diethoxydiphenylmethane-4,4'-diisocyanate, tolylene diisocyanate, 1,5-naphthylene diisocyanate, xylylene diisocyanate and tetramethlenexylylene diisocyanate, in addition to these, a dimmer, a trimer or an adduct of each above-described isocyanate (such as a 2-mol-adduct of hexamehylene diisocyanate, a 3-mol-adduct of hexamehylene diisocyanate, a 2-mol-adduct of 2,4-tolylene diisocyanate and a 3-mol-adduct of 2,4-tolylenediisocyanate), an adduct of two or more types of isocyanates being different to each other selected from these isocyanates and adducts (such as an adduct of tolylene diisocyanate and trimethylol propane and an adduct of hexamethylene diisocyanate and trimethylol propane) of these isocyanates and dihydric or trihydric polyalcohols (such as diethylene glycol, polyethylene glycol, dipropylene glycol, polypropylene glycol, polytetramethylene glycol and trimethylol propane). These isocyanate compounds may be utilized alone or in combination of two or more types.

Herein, with respect to the isocyanate compounds described above, a holographic information medium, which is utilized in a state of finishing recording of whole information on a holographic recording medium, in which a recording layer comprising a holographic recording composition, detailed later is accumulated, is possibly exposed to variety of environmental temperatures at which the holographic information medium is placed under a fluorescent lamp or by the window or is allowed to stand similar to such as a CD and a DV. Therefore, preferable are those to depress coloration of a recording layer under variety of conditions, and aliphatic isocyanate compounds among the above compounds are more preferable to depress such coloration.

Besides, if it does not prevent particularly the object of the present invention, the compound which has the isocyanate group used when making it a binder by carrying out the crosslinking with the combination of the compound

which has the isocyanate group of (1), and the compound which has a hydroxyl group can be used without a restriction. As a compound which has an isocyanate group, in order to make it a high-molecular weight binder by a crosslinking reaction with the compound which has two or more hydroxyl groups in above-mentioned molecular, the compound which has two or more hydroxyl groups in molecular is more preferable, and furthermore, the compound which has two or more alcoholic groups of an aliphatic sries in molecular is more preferable in order to make easy to control the rigidity measured with durometer.

Such compounds provided with at least two alcoholic hydroxyl groups in the molecule include such as diethylene glycol, triethylene glycol, polyethylene glycol, dipropylene glycol, tripropylene glycol, polypropylene glycol, 2,2-dimethyl-1,3-propanediol, 2,2-diethyl-1,3-propanediol, 2-butyl-2-ethyl-1,3-propanediol, 1,2-butanediol, 1,4-butanediol, polytetramethylene glycol, 1,5-pentanediol, 2-methyl-2,4-pentanediol, 3-methyl-1,5-pentanediol, 1,6-hexanediol, 2-ethyl-1,3-hexanediol, 2,5-dimethyl-2,5-hexanediol, 1,10-decanediol, 1,4-cyclohexanediol, glycerin, 1,2,6-hexanetriol, trimethylolethane, trimethylolpropane, pentaerythritol and sorbitol, in addition to these, alcohols in which the above-described compounds provided with at least two alcoholic hydroxyl groups in the molecule are modified with bihydric alcohols such as ethylene glycol, diethylene glycol, triethylene glycol, polyethylene glycol, propyrene glycol, dipropylene glycol, tripropylene glycol, polypropylene glycol and polytetramethylene glycol. Herein, these compounds provided with at least two alcoholic hydroxyl groups in the molecule may be utilized alone or in combination of two or more types.

The molecular weight of a compound provided with at least two aliphatic type alcoholic hydroxyl groups in the molecule is preferably 100 - 2000 taking into consideration volatility of the compound itself and compatibility or solubility with a compound provided with an ethylenic unsatulated bond, a compound provided with a functional group which can perform cationic polymerization or a photopolymerization initiator, and the addition amount of a compound provided with at least two aliphatic type alcoholic hydroxyl groups in the molecule cannot be defined unequivocally with respect to the types and addition amount of an isocyanate compound as an essential component described above, however, is generally in a range of $0.5 \leq N/M \leq 2.0$ and more preferably $0.7 \leq N/M \leq 1.5$, when a mol number of isocyanate groups being present in a holographic recording composition of a compound provided with an isocyanate group is N [mol] and a mol number of hydroxyl groups being present in a holographic recording composition of the aforesaid compound provided with an alcoholic hydroxyl group is M [mol], with respect to compatibility and control of cross-linking reaction.

Further, as a compound provided with an oxirane group in the molecule and a compound provided with a mercaptan group when a binder is formed by polymerizing a compound provided with an oxirane group and a compound provided with a mercaptan group, commonly known compounds capable of cross-linking can be utilized without limitation, however, a compound which is a liquid at ordinary temperature or has a melting point of not higher than 100°C is preferred and a compound provided with at least two oxirane groups or mercaptan groups are more preferred, because at the time of preparation of a holographic recording medium of this invention, which will be detailed later, it is prepared by sandwiching a recording composition which is a liquid at ordinary temperature or has a melting point of not higher than 100 °C between two substrates at a predetermined thickness.

Further, it is preferable to incorporate a Brøensted base or a Lewis base when a binder is formed by polymerizing a compound provided with an oxirane group and a compound provided with a mercaptan group, with respect to polymerization at milder conditions, and such bases include amine compounds such as pyridine, pyperidine, dimethylaniline, 2,4,6-tris(dimethylaminomethyl)benzene and 2,4,6-tris(dimethylamnomethyl) phenol.

Furthermore, as a compound used when carrying out the crosslink with the compound which has, in molecule, one or more groups chosen from oxirane, oxetane, tetrahydrofuran, oxepane, single ring acetal, a double ring acetal, lactone, cyclic ortho ester, and cyclic carbonate using a heat acid generator, any compound having the above-mentioned functional group can be used without a paticluar restriction.

In producing the holographic recording media of the present invention mentioned later, the composite for recording liquefied in normal temperature or liquefied at the temperature of 100 degrees Celsius or less is sandwiched between the first substrate and second substrate with prescribed thickness. For this reason, as the composite for recording, the compound which is liquefied in normal temperature, or has a melting point of 100degree-Celsiusdegree Celsius is preferable.

If it does not have a deteriorate effect on other essential ingredients concerning the present invention, as a thermal polymerization initiator which can construct a bridge in the compound which has above-mentioned oxirane or an above-mentioned oxetane group in a molecule, onium, silanol aluminium complexes, etc., such as a conventionally well-known sulfonium salt, ammonium salt, and a phosphonium salt, can be particularly used without a restriction. If other essential ingredients are satisfactory in these thermal polymerization initiators even if they heat at an elevated temperature 150 degrees Celsius or more, as the tri alkyl sulfonium salt described by the benzyl sulfonium salt described by each official gazette of JP-A No. 58-37003 and No. 63-223002 etc., JP-A No. 56-152833, etc., and a compound which can start polymerization at low temperature further, the compound described by each following official gazette can be cited: JP-A No. 63-8365, No. 63-8366, JP-A No. 1-83060, No. 1-290658, No. 2-1470, No. 2-196812, No. 2-232253, No. 3-17101, No. 3-47164, No. 3-48654, No. 3-145459, No. 3-200761, No. 3-237107, No. 4-1177, No. 4-210673, No. 8-188569, No. 8-188570, No. 11-29609, No. 11-255739 , JP-A No. 2001 -55374.

Such a thermal polymerization initiator can be used independently, or two or more sorts of thermal polymerization initiators also can be used in combination as required.

Furthermore, the thermal polymerization initiator described in detail above can also be used in order to start polymerization of the compound which has, in a molecule, oxirane group or oxetane group using the carbonium cation generated by which the start itsself is generated by cleaving thermally. Moreover, when the compound which has protogenic functional groups, such as a hydroxyl group, exists in the composite for holographic recording, the above-mentioned thermal polymerization initiator can also be used in order to start polymerization of the compound which has, in a molecule, proton and oxirane, or oxetane group using the carbonium cation generated by which the start itsself is generated by cleaving thermally.

Moreover, the amount of adding a thermal polymerization initiator mentioned above is usually 0.01 weight parts or more and 10 weight parts to the 100 weight parts of compounds which have in a molecule the oxirane or an oxetane group which can carry out cationic polymerization, and it is preferably 0.05 weight parts or more and 5 weight parts or less.

It is preferable that there is a difference between a reflective index of the binder formed by reacting a binder forming compound and a reflective index of the photopolymerized compound formed by photopolymerizing a compound which has a functional group being capable of photopolymerization without a practical problem including reduction of transmission and increasing haze. Particularly, a compound provided with an ethylenic unsaturated bond as a compound has a functional group being capable of photopolymerization is easy to obtain a high-reflective index Compound having the reflective index of more than 1.55. In this case, it is preferable that selecting a binder compound so that the refractive index of a binder formed by the binder forming compound is less than a refractive index of a polymerized compound formed by polymerization of the photopolymerizable compound having the functional group being capable to photopolymerize.

Such compounds provided with a (meth)acryloyl group having a refractive index of not lower than 1.55 include generally compounds provided with at least two hetero atoms such as nitrogen, oxygen, sulfur and phosphor, halogen atoms such as chlorine, bromine and iodine or aromatic rings, and specific examples of these compounds include paracumylphenoxyethylene glycol acrylate, paracumylphenoxyethylene glycol methacrylate, hydroxyethylated o-phenylphenol acrylate, hydroxyethylated β-naphthol acrylate, tribromophenyl acrylate, tribromophenyl methacrylate, triiodophenyl methacrylate, polyethyleneoxide modified tetrabromobisphenol A diacrylate, polyethyleneoxide modified tetrabromobisphenol A dimethacrylate, bis (4-methacryloylthiophenyl)sulfide, and compounds provided with a fluorene skeleton described in JP-A Nos. 6-301322, 2000-344716 and 2003-29604.

Further, for the purposes of such as to control compatibility and viscosity at the time of preparation of a holographic recording layer composition and to control dispersion polymerization at the time of holographic exposure, a compound provided with a (meth)acryloyl group having a refractive index of less than 1.55 may also be added in a range of not disturbing the purpose of providing a refractive index difference between a binder formed from a binder forming compound and a diffusion polymerization product of a compound provided with an ethylenic unsaturated bond.

Herein, the aforesaid compound provided with an ethylenic unsaturated bond may be utilized alone or in combination of two or more types, the content is generally 1.0 - 50 weight% and preferably 4.0 - 40 weight%, based on a holographic recording composition.

As a photopolymerization initiator to photopolymerize a compound provided with an ethylenic unsaturated bond, In addition to the aforesaid compounds, utilized in combination may be commonly known conventional photopolymrization initiators such as benzoine and derivatives thereof, carbornyl compounds such as benzophenone, azo compounds such as azobisbutyronitrile, sulfer compounds such as dibenzothiazolylsulfide, peroxides such as benzoyl peroxide, halogen compounds such as 2-tribromomethane sulfonylpyridine, quartenary ammonium salts or substituted or unsubstituted diphenyliodonium salts, onium compounds such as a triphenylsulfonium salt, bisimidazol compounds such as 2,2-bis (o-chlorophenyl)-4,4',5,5'-tetraphenylbiimidazol. The well-known photopolymerization initiator represented by the metal π complex containing iron arene complexes such as (η6-cumene) (η5-cyclopentadienyl) iron (1+) hexafluorophosphate, and titanocene complexes, such as di-η(5)-cyclopentadienyl bis [2, 6-difluoro-3-(pyrrole-1-yl) phenyl] titanium (IV), and the complex with borate anion of cationic dye can be suitably chosen and used. In these, at least one sort of compounds particularly chosen from a bis imidazole compound, a metal n complex, and a complex with borate anion of cationic dye are more preferable from the field of sensitiveness or stability. Furthermore, particularly in a metal n complex, an iron arene complex is more preferable.

Furthermore, when the exposure light source wavelength used for holographic exposure described below does not have absorption to the wavelength of the laser light source used for holographic exposure of that photopolymerization initiator, or has very small absorption though it has the absorption, it is more preferable that it is used together with the sensitizing dye for carrying out wavelength sensitization of the spectrum wavelength of a photopolymerization initiator.

Herein, sensitizing dyes to spectrally sensitize the photopolymerization initiators utilized here include variety of dyes well known in the art, and for example, variety of dyes such as cumalin derivatives, methine derivatives, polymethine derivatives, triarylmethane derivatives, indoline derivatives, azine derivatives, thiazine derivatives, xanthene derivatives, thioxanthene derivatives, oxazine derivatives, acrydine derivatives, cyanine derivatives, carbocyanine derivatives, merocyanine derivatives, hemicyanine derivatives, rhodacyanine derivatives, azamethine derivatives, styryl derivatives, pyrylium derivatives, thiopyrylium derivatives, porphyradine derivatives, porphyrin derivatives, phthalocyanine derivatives and pyrromethene derivatives can be utilized alone or appropriately in combination of two or more types. As specific examples of such a photopolymerization initiator or a sensitizing dye, utilized by suitable selection can be those described, for example, in USP Nos. 5,027,436, 5, 096, 790, 5, 147, 758, 5,204,467, 5,256,520 and 6, 011, 180 ; European Patent Nos. 255, 486, 256, 981, 277, 915, 318,893, 401,165 and 565, 488; JP-A Nos. 2-236553, 5-46061, 5-216227, 5-247110, 5-257279, 6-1 75554, 6-175562, 6-175563, 6-175566, 6-186899, 6-195015, 6-202540, 6-202541, 6-202543, 6-202544, 6-202548, 6-324615, 6-329654, 7-13473, 7-28379, 7-84502, 7-84503, 7-181876, 9-106069, 9-309907, 2002-60429, 2002-62786, 2002-244535 and 2002-296764.

The above-described photopolymerization initiator to photopolymerize a compound provided with an ethylenic unsaturated bond cannot be ununequivocally defined depending on the molecular weight of a photopolymerization initiator or the occupying ratio of ethylenic unsaturated bonds in a compound provided with an ethylenic unsaturated bond, however, in general, is preferably utilized in a range of 0.01 - 25 weight parts based on a compound provided with an ethylenic unsaturated bond. Further, a sensitizing dye which can spectrally sensitize a photopolymerization initiator cannot be ununequivocally defined depending on the molecular weight or mol absorbance of a dye itself, however, in general, is preferably utilized in a range of 0.01 - 25 weight parts based on a photopolymerization initiator.

As a method to prepare the recording medium detailed above, a holographic recording layer forming composition is prepared by mixing a holographic recording layer composition under a safelight at ordinary temperature or while being appropriately heated, and a holographic recording layer forming composition is applied on the first substrate at ordinary temperature or while being appropriately heated after the composition has been degassed to depress polymerization inhibition at the time of holographic exposure, then the second substrate is laminated thereon to make a predetermined thickness of a recording layer without introducing bubbles, finally the edge portions are sealed resulting in preparation of a recording medium. Further, the first substrate and the second substrate are fixed under a safelight in a form so as to have a predetermined space, and a holographic recording layer composition is filled between the first substrate and the second substrate by means of injection molding not to introduce bubbles or by means of reduced pressure suction not to introduce bubbles, finally the edge portions are sealed resulting in preparation of a recording medium. Herein, under a safelight means an operation in a state of wavelengths of light which activates a photopolymerizatuin initiator being cut.

Further, in the case of forming a recording medium by means of lamination, a holographic recording layer forming composition may be applied not on the first substrate but on the second substrate, or may be applied on the both of the first and second substrates. Further, to seal the edge portions of the first substrate, a holographic recording layer and the second substrate, sealing may be performed by cross-linking a liquid end-sealing material represented by a moisture curable type adhesive or by use of a ring-form end-sealing material which can keep a predetermined thickness of a holographic recording layer in advance.

Next, a method to record information on a holographic recording medium will be detailed.

A holographic recording method of the invention is characterized of including the steps of: reacting the binder forming compound for forming a binder; holographic exposing a surface of the anti-reflection layer of the holographic recording medium based on the information for generating activated species by activating the photopolymerization initiator; and diffusion polymerizing the photopolymerizable compound by the activated species in the holographic recording layer.

Generally, since a recording layer forming composition is prepared without a solvent to apply a thick layer, it is difficult to obtain a uniform thickness or to eliminate bubbles incorporated at the time of preparation of the composition in a solid or highly viscous composition. Therefore, fluidity is required in a state of ordinary temperature or being heated when a recording layer forming composition is prepared. In particular, it is not preferable when this recording layer forming composition is a liquid and has a low viscosity at ordinary temperature, because flatness as a recording medium is hard to be secured or there is a possibility of position shifting of a polymer, which has been formed from a compound which has a functional group being capable of photo polymerization, in a recording layer.

Therefore, in a holographic recording medium containing the aforesaid essential component, it is possible to secure the flatness and to prevent the shift of a polymer, which has been formed by diffusion polymerization of a compound which has a functional group being capable of photo polymerization, in a holographic recording layer, by cross-linking a binder forming compound before holographic exposure.

Therefore, in a holographic recording medium containing the aforesaid essential component, it is possible to secure the flatness and to prevent the shift of a polymer, which has been formed by diffusion polymerization of a compound which has a functional group being capable of photo polymerization, in a holographic recording layer, by cross-linking a binder forming compound before holographic exposure.

Furthermore, the crosslinking reaction for making the above-mentioned binder in the holographic recording method of the present invention form may carry out the crosslinking of all the combination of the functional group in which a reaction is possible, and only a portion may carry out a crosslinking in the scope which does not make trouble

in practical experience. Furthermore, after recording information on a holographic recording media, photopolymerization of the compound which has at least one or more functional groups which remain in a recording layer, and which can be photopolymerized with the heat applied a light and if necessary in order to fix the recorded holographic information is carried out with a photopolymerization initiator. Moreover, when there is a functional group which is not crosslinked with the binder formation compound, it is preferable to carry out the heat crosslinking the functional groups which is not clisslinked each other. In this case, it is preferable to carry out one-shot exposure of the light used for exposure to the whole holographic recording media. When heating as occasion demands, being heated may be any after simultaneous with one-shot exposure, or one-shot exposure before one-shot exposure, and a plurality of heat-treatment may be combined.

Moreover, there is particularly no restriction in the apparatus which records and reproduces the holographic recording media used for holographic data processing of the present invention, when it can be recorded and reproduced to the holographic recording media of the present invention. As such recording and apparatus to reproduce, each leaflet of followings can be cited, for example: each official gazette of each specification of United States Patent No. 5,719,691, No. 5,838,467, No. 6,163,391, No. 6,414,296, the United States Patent application disclosure 2.002/136143, JP-A No. 9-305978, No. 10-124872, No. 11-219540, JP-A No. 2000-98862, No. 2000-298837, No. 2001-23169, No. 2002-83431, No. 2002-123949, No. 2002-123948, and No. 2003-43904, international publications Nos. 99/57719, 02/05270, 02/75727.

It can use without restricting, particularly when it is the laser light source which can activate the photopolymerization initiator in a recording media and can read a holographic recording possibility and the recorded hologram as a laser light source used for recording described above and the apparatus to reproduce. As such a light source, the semiconductor laser of a violet blue color region, an Ar laser, He-Cd laser, a frequency duplex YAG laser, He-Ne laser, Kr laser, the semiconductor laser of a near infrared region, etc. can be cited.

Moreover, a postscript may be added to the holographic recording media before recording, and a holographic recording media with little recorded information. For this reason, when wavelength of the light source usually used for holographic recording is set to $\lambda$ nm, a holographic recording media is kept and placed in a case or a cassette which can shade light with a wavelength of ($\lambda$+100) nm or below, preferably ($\lambda$+200) nm or below. When exposing and recording a laser light on the above-mentioned holographic recording media, information is recorded by irradiating a laser light under unloading and shielding from a case or a cassette.

Furthermore, the holographic recording medium on which information was recorded by holographic data processing of the present invention is taken out from a case, a cassette, etc. which were mentioned above and which can be shaded, and can be used like CD, DVD, etc. as holographic information media which can be dealt with by a non--darkened room. The holographic information medium which reproduce information by the light which a read-out light is entered from the first substrate side, and is transmitted from the second substrate side are characterized in containing: an anti-reflection layer; an first substrate; a holographic information recording layer containing a binder area containing the binder as major component formed by reacting a binder forming compound and a photopolymerized area containing a photopolymerized compound a major component formed by photopolymerizing a compound which has a functional group being capable of photopolymerization, and a refractive index of the binder area is lower than a refractive index of the photopolymerized area; a second substrate, in that order,
wherein at least one of the first substrate and the second substrate is a plastic substrate having a light transmittance of more than 90% measured according to ASTM D1003 at a thickness of 3 mm.

Moreover, the holographic information media which reproduce information by the light which a read-out light is entered from the first substrate side, and is reflected from the first substrate side are characterized that:

> the holographic information recording layer contains a binder area containing the binder as major component formed by reacting a binder forming compound and a photopolymerized area containing a photopolymerized compound a major component formed by photopolymerizing a compound which has a functional group being capable of photopolymerization, and a refractive index of the binder area is lower than a refractive index of the photopolymerized area; and
> at least one surface of the second substrate is covered with a reflection layer having a reflectance of more than 80%.

At these holographic information media, there is almost no read-out deterioration with the regenerative apparatus by temporality or storage environment.

**[EXAMPLES]**

This invention will be described in further detail by way of embodiments. However, it is to be understood that this invention is not intended to be limited to the specific embodiments.

A base material of 0.5 $\pm$0.05 mm thick is prepared as described below. The surface accuracy of the base

material is 3λ or less. Its total light transmittance is measured in conformance to ASTM D1003 (3 mm thick). The surface accuracy λ is a reflection wave-front accuracy measured at a wavelength of 632 nm.

<Base material>

(S-1) Polished glass (made of BK7 whose total light transmittance is greater than 92%)
(S-2) Polymethylmethacrylate (Sumipeck LG35 fabricated by Sumitomo Chemical Co., Ltd.: Total light transmittance = 92% and Tg = 102°C)
(S-3) Bisphenol-A polycarbonate (IupilonH-4000 fabricated by Mitsubishi Engineering-Plastics Corp.: Total light transmittance - 90% and Tg = 145°C)
(S-4) Resin containing cyclic olefin as a monomer (APL6015 fabricated by Mitsui Chemicals, Inc.: Total light transmittance = 90% and Tg = 145 °C)
(S-5) Resin containing cyclic olefin as a monomer (APL6011 fabricated by Mitsui Chemicals, Inc.: Total light transmittance = 90% and Tg = 105 °C)
(S-6) Resin containing cyclic olefin as a monomer (ARTON F5023 fabricated by JSR: Total light transmittance = 93% and Tg = 167 °C)
(S-7) Resin containing cyclic olefin as a monomer (ARTON FX4726 fabricated by JSR: Total light transmittance = 93% and Tg = 1 25 °C)
(S-8) Resin containing cyclic olefin as a monomer (ZEONOR 1020R fabricated by ZEON Corp.: Total light transmittance = 92% and Tg = 105 °C)
(S-9) Resin containing cyclic olefin as a monomer (ZEONOR 1600R fabricated by ZEON Corp.: Total light transmittance = 92% and Tg = 163 °C)
(S-10) Resin containing cyclic olefin as a monomer (ZEONEX 480R fabricated by ZEON Corp.: Total light transmittance = 92% and Tg = 138 °C)
(S-11) Resin containing 1,1-bis(4-hydroxyphenyl) cyclohexane as a monomer (Iupilon Z-400 fabricated by Mitsubishi Engineering-Plastics Corp.: Tg = 175 °C)
(S-12) Resin containing 1,1-bis(4-hydroxyphenyl)-3,3,5-trimethyl cyclohexane as a monomer (Apeck 1600 fabricated by Bayer: Total light transmittance = 90% and Tg = 160 °C)
(S-13) Resin containing 1,1-bis(4-hydroxyphenyl)-3,3,5-trimethyl cyclohexane as a monomer (Apeck 2000 fabricated by Bayer: Total light transmittance = 90% and Tg = 200 °C)
(S-14) Resin expressed by the above general formula (1) (Above B-10: Total light transmittance = 90% and Tg = 140 °C).

An anti-reflection layer or reflection layer is formed on one side of each of the above base materials by the surface treatments below. Table 1 lists prepared base materials 1-1 to 1-4 (or S-1 to S-4), anti-reflection layer laminated base materials (having an anti-reflection layer on the surface of the base material) 1-5 to 1-22, and reflection layer laminated base materials (having a reflection layer on the surface of the base material) 2-1 to 2-5. In Table 1, the mass ratios per unit area mean the ratio of mass of respective base materials 1-1 to 1-4 to mass (100) of base material 1-1, the ratio of mass of respective anti-reflection layer laminated base material 1-5 to 1-22 to mass (100) of laminated base material 1-5, and the ratio of mass of respective reflection layer laminated base material 2-1 to 2-5 to mass (100) of laminated base material 2-1.

(Anti-reflection layer 1)

An anti-reflection layer of $MgF_2$ was formed on the surface of the base material by the vapor deposition method. The layer has a reflectivity of Table 1 .

(Anti-reflection layer 2)

Five $SiO_2/ZrO_2/Al_2O_3$ related anti-reflection layers are deposited on a base material in the order of $SiO_2$, $ZrO_2$, $SiO_2$, $Al_2O_3$, and $SiO_2$ + $Al_2O_3$ (outward from the base material) by a vapor deposition method. Their thicknesses are respectively λ0/12, λ0/2, λ0/12, λ0/4, and λ0/1 in that order (where λ0 is a light wavelength of 532 nm).

(Reflection layer 1)

An aluminum layer of 1000 nm thick is formed on a base material by a vapor deposition method.

Table 1

| | base material | | | | anti-reflection layer | reflection layer | mass ratios per unit area | reflectivity [%] |
|---|---|---|---|---|---|---|---|---|
| | | water absorption rate [%] *1 | oxygen permeability [$cm^3 \cdot mm/m^2 \cdot 24hr \cdot Mpa$] *2 | water vapor transmission rate [g/($cm^2 \cdot 24hr$)] *3 | | | | |
| Substrate 1-1 | S-1 | <0.01 | <1 | <0.01 | - | - | 100 | 4.1 |
| Substrate1-2 | S-2 | 0.30 | - | - | - | - | 47 | 5.5 |
| Substrate1-3 | S-3 | 0.24 | 1200 | 4.05 | - | - | 47 | 7.3 |
| Substrate1-4 | S-4 | <0.01 | 250 | 0.09 | - | - | 41 | 6.2 |
| *4 1-5 | S-1 | <0.01 | <1 | <0.01 | 1 | - | 100 | 0.1 |
| *4 1-6 | S-2 | 0.30 | - | - | 1 | - | 47 | 0.4 |
| *4 1-7 | S-3 | 0.24 | 1 200 | 4.05 | 1 | - | 47 | 0.5 |
| *4 1-8 | S-4 | <0.01 | 250 | 0.09 | 1 | - | 41 | 0.3 |
| *4 1 -9 | S-5 | <0.01 | 250 | 0.09 | 1 | - | 41 | 0.3 |
| *4 1-10 | S-6 | 0.21 | - | - | 1 | - | 42 | 0.3 |
| *4 1-11 | S-7 | 0.11 | - | - | 1 | - | 42 | 0.3 |
| *4 1-12 | S-8 | <0.01 | 90 | 0.15 | 1 | - | 40 | 0.3 |
| *4 1-13 | S-9 | <0.01 | 90 | 0.15 | 1 | - | 40 | 0.3 |
| *4 1-14 | S-10 | <0.01 | 90 | 0.15 | 1 | - | 40 | 0.3 |
| *4 1-15 | S-11 | 0.30 | - | - | 1 | - | 46 | 0.5 |
| *4 1-16 | S-12 | 0.40 | - | - | 1 | - | 46 | 0.5 |
| *4 1-17 | S-13 | 0.40 | - | - | 1 | - | 45 | 0.5 |
| *4 1-18 | S-14 | 0.30 | - | - | 1 | - | 46 | 0.5 |
| *4 1-19 | S-3 | 0.24 | 1200 | 4.05 | 2 | - | 47 | 0.8 |
| *4 1-20 | S-4 | <0.01 | 250 | 0.09 | 2 | - | 41 | 0.7 |
| *4 1-21 | S-6 | 0.21 | - | - | 2 | - | 40 | 0.7 |
| *4 1-22 | S-8 | <0.01 | 90 | 0.15 | 2 | - | 40 | 0.8 |
| *5 2-1 | S-1 | <0.01 | <1 | <0.01 | - | 1 | 100 | >90 |
| *5 2-2 | S-2 | 0.30 | - | - | - | 1 | 47 | >90 |
| *5 2-3 | S-3 | 0.24 | 1200 | 4.05 | - | 1 | 47 | >90 |
| *5 2-4 | S-4 | <0.01 | 250 | 0.09 | - | 1 | 41 | >90 |
| *5 2-5 | S-8 | <0.01 | 90 | 0.15 | - | 1 | 40 | >90 |

*1: the water absorption specified by ASTM D570 (23 °C, one week)
*2: the oxygen permeability specified by ASTM D3985
*3: the water vapor transmission rate specified by ASTM F1249
*4: Anti-reflection layer laminated substrate : Reflection layer laminated substrate

<<Preparation of compositions for forming holographic recording layers>>

(Composition 1 forming holographic recording layers)

Under a safe light, solution 1 was prepared by adding 11.0 mg of sensitizing dye (see Structural formula 1

below) and 34.0 mg of urethane hardening catalyst (NEOSTAN U-600 fabricated by NITTOH KASEI Co., Ltd.) to 65.555 g of polypropylene glycol (UNIOL D-1000 fabricated by NOF Corp.) and mixing thereof under a safety light. Meanwhile, solution A was prepared by mixing 5.983 g of 2-isocyanateethyl-2,6-diisocyanate caproate, 17.948 g of polyisocyanate material of hexamethylene di-isocyanate (Duranate D-101 fabricated by Asahi Kasei Corp.), 8.000 g of bisphenoxyethanol fluorine diacrylate (BPEFA fabricated by Osaka Gas Co., Ltd.), 2.000 g of phenoxyethyl acrylate and 36.0 mg of 2,6-di-(t-butyl)-4-methylphenol under a safe light. Into this solution A was added 0.500 g of (η6-cumene) (η5-cyclopenta-di-enyl) iron (1+) hexafluorophosphate. This solution was added to solution 1. Nitrogen gas was blown into the resulting solution to substitute air in the solution by nitrogen gas. The solution was ultrasonically vibrated to remove gas components from the solution. The product is composition 1 forming holographic recording layers.

(Composition 2 forming holographic recording layers)

Under a safe light, solution 2 was prepared by adding 50.000 g of 3-etluyl-3- (phenoxymethyl) oxetane, 39. 320 g of bis[1-ethyl (3-oxetanyl)]methylether, 9.00 g of EO denatured tri-bromo phenyl acrylate (New Frontier BR-31 fabricated by DAI-ICHI KOGYO SEIYAKU Co., Ltd.), 1.00 g of phenoxyethyl acrylate, 0.923 g of (η6-cumene) (η5-cyclopenta-di-enyl) iron (1+) hexafluoro antimonate, and 9.6 mg of sensitizing dye (see Structural formula 2 below). Into this solution 2 was dissolved 0.179 g of thermal polymerization initiator (Sun-aid SI-45 fabricated by SANSHIN CHEMICAL INDUSTRY Co., Ltd.) Nitrogen gas was blown into the resulting solution to substitute air in the solution by nitrogen gas. The solution was ultrasonically vibrated to remove gas components from the solution. The product is composition 2 forming holographic recording layers.

Structural formula (1) and Structural formula (2)

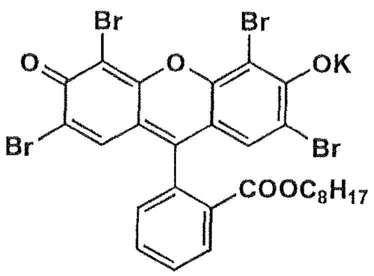

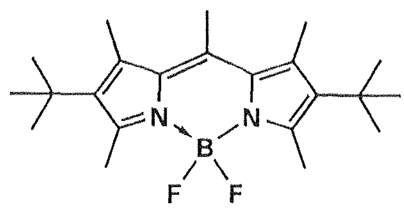

<<Preparation of holographic recording media>>

(Preparation method 1)

Using base materials and anti-reflection layer laminated base materials in Table 1, a holographic recording medium is prepared by attaching the primary anti-reflection layer laminated base material (first anti-reflection layer laminated substrate) of 0.5 mm thick (D1) to the primary base material (first substrate) and the secondary anti-reflection layer laminated base material (second anti-reflection layer laminated substrate) of 0.5 mm thick (D2) to the secondary base material (second substrate), attaching a composition for forming a holographic recording layer to the opposite side of the primary base material (the side without the primary anti-reflection layer) with a resin sheet spacer between the primary base material and the composition layer to make the thickness (Dh) of the recording layer equal to that described in Table 2, attaching the opposite side of the secondary base material (the side without the secondary anti-reflection layer laminated base material) to the composition layer of the primary base material with a spacer therebetween without letting any air be there, sealing the outer edges of the assembly with a moisture-hardening adhesive, and bridging the binder-forming compound under the bridging condition of Table 2. The mass ratios per unit area in the table are values relative to those (100) of holographic recording medium 1.

Table 2

| | Holographic recording medium No. | first substrate and first anti-reflection layer laminated substrate No. | composition for forming holographic recording layers No. | second substrate and second anti-reflection layer laminated substrate No. | condition of heat-treatment | | Thickness of the recording layer Dh(mm) | Dh/(D1+D2) | mass ratios per unit area |
|---|---|---|---|---|---|---|---|---|---|
| | | | | | Temperature (°C) | Time (hr) | | | |
| Comp. | *1 1 | 1-1 | composition 1 | 1-1 | 25 | 72 | 0.50 | 0.50 | 100 |
| Comp. | *1 2 | 1-2 | composition 1 | 1-2 | 25 | 72 | 0.50 | 0.50 | 56 |
| Comp. | *1 3 | 1-3 | composition 1 | 1-3 | 25 | 72 | 0.50 | 0.50 | 56 |
| Comp. | *1 4 | 1-4 | composition 1 | 1-4 | 25 | 72 | 0.50 | 0.50 | 51 |
| Comp. | *1 5 | 1-5 | composition 1 | 1-1 | 25 | 72 | 0.50 | 0.50 | 100 |
| Inv. | *1 6 | 1-6 | composition 1 | 1-2 | 25 | 72 | 0.50 | 0.50 | 56 |
| Inv. | *17 | 1-7 | composition 1 | 1-3 | 25 | 72 | 0.50 | 0.50 | 56 |
| Inv. | *1 8 | 1-8 | composition 1 | 1-4 | 25 | 72 | 0.50 | 0.50 | 51 |
| Comp. | *1 9 | 1-5 | composition 1 | 1-5 | 25 | 72 | 0.50 | 0.50 | 100 |
| Inv. | * 1 10 | 1-6 | composition 1 | 1-6 | 25 | 72 | 0.50 | 0.50 | 56 |
| Inv. | *1 11 | 1-7 | composition 1 | 1-7 | 25 | 72 | 0.50 | 0.50 | 56 |
| Inv. | *1 12 | 1-8 | composition 1 | 1-8 | 25 | 72 | 0.50 | 0.50 | 51 |
| Inv. | *1 13 | 1-9 | composition 1 | 1-9 | 25 | 72 | 0.50 | 0.50 | 51 |
| Inv. | *1 14 | 1-10 | composition 1 | 1-10 | 25 | 72 | 0.50 | 0.50 | 52 |
| Inv. | *1 15 | 1-11 | composition 1 | 1-11 | 25 | 72 | 0.50 | 0.50 | 51 |
| Inv. | *1 16 | 1-12 | composition 1 | 1-12 | 25 | 72 | 0.50 | 0.50 | 50 |
| Inv. | *1 17 | 1-13 | composition 1 | 1-13 | 25 | 72 | 0.50 | 0.50 | 50 |
| Inv. | *1 18 | 1-14 | composition 1 | 1-14 | 25 | 72 | 0.50 | 0.50 | 50 |
| Inv. | *1 19 | 1-15 | composition 1 | 1-15 | 25 | 72 | 0.50 | 0.50 | 55 |
| Inv. | *1 20 | 1-16 | composition 1 | 1-16 | 25 | 72 | 0.50 | 0.50 | 55 |
| Inv. | *1 21 | 1-17 | composition 1 | 1-17 | 25 | 72 | 0.50 | 0.50 | 54 |

(continued)

| | Holographic recording medium No. | first substrate and first anti-reflection layer laminated substrate No. | composition for forming holographic recording layers No. | second substrate and second anti-reflection layer laminated substrate No. | condition of heat-treatment | | Thickness of the recording layer Dh(mm) | Dh/(D1+D2) | mass ratios per unit area |
|---|---|---|---|---|---|---|---|---|---|
| | | | | | Temperature (°C) | Time (hr) | | | |
| Inv. | *1 22 | 1-18 | composition 1 | 1-18 | 25 | 72 | 0.50 | 0.50 | 55 |
| Inv. | *1 23 | 1-19 | composition 1 | 1-19 | 25 | 72 | 0.50 | 0.50 | 56 |
| Inv. | *1 24 | 1-20 | composition 1 | 1-20 | 25 | 72 | 0.50 | 0.50 | 51 |
| Inv. | *1 25 | 1-21 | composition 1 | 1-21 | 25 | 72 | 0.50 | 0.50 | 52 |
| Inv. | *1 26 | 1-22 | composition 1 | 1-22 | 25 | 72 | 0.50 | 0.50 | 50 |

*1 : recording medium

(Preparation method 2)

Using base materials and anti-reflection layer laminated base materials in Table 1,
a holographic recording medium is prepared by attaching a composition for forming a holographic recording layer (as a reflection laminated base material of 0.5 mm thick (D2)) to the primary base material (on the side without the primary anti-reflection layer) and the primary anti-reflection layer laminated base material of 0.5 mm thick (D1) with a resin sheet spacer between the primary base material and the composition layer to make the thickness (Dh) of the recording layer equal to that described in Table 3, attaching the aluminum deposited surface of the reflection layer laminated base material to the composition layer with a spacer therebetween without letting any air be there, sealing the outer edges of the assembly with a moisture-hardening adhesive, and bridging the binder-forming compound under the bridging condition of Table 3. The mass ratios per unit area in the table are values relative to those (100) of holographic recording medium 27.

Table 3

| | Holographic recording medium No. | first substrate and first anti-reflection layer laminated substrate No. | composition for forming holographic recording layers No. | reflection layer laminated substrate No. | condition of heat-treatment | | Thickness of the recording layer Dh (mm) | Dh/(D1+D2) | mass ratios per unit area |
|---|---|---|---|---|---|---|---|---|---|
| | | | | | Temperature (°C) | Time (hr) | | | |
| Comp. | *1 27 | 1-1 | composition 2 | 2-1 | 25 | 48 | 0.50 | 0.50 | 100 |
| Comp. | *1 28 | 1-2 | composition 2 | 2-2 | 25 | 48 | 0.50 | 0.50 | 56 |
| Comp. | *1 29 | 1-3 | composition 2 | 2-3 | 25 | 48 | 0.50 | 0.50 | 56 |
| Comp. | *1 30 | 1-4 | composition 2 | 2-4 | 25 | 48 | 0.50 | 0.50 | 51 |
| Comp. | *1 31 | 1-5 | composition 2 | 2-1 | 25 | 48 | 0.50 | 0.50 | 100 |
| Inv. | *1 32 | 1-6 | composition 2 | 2-2 | 25 | 48 | 0.50 | 0.50 | 56 |
| Inv. | *1 33 | 1-7 | composition 2 | 2-3 | 25 | 48 | 0.50 | 0.50 | 56 |
| Inv. | *1 34 | 1-8 | composition 2 | 2-4 | 25 | 48 | 0.50 | 0.50 | 51 |
| Inv. | *1 35 | 1-12 | composition 2 | 2-5 | 25 | 48 | 0.50 | 0.50 | 50 |
| Inv. | *1 36 | 1-6 | composition 1 | 2-4 | 25 | 72 | 0.50 | 0.50 | 53 |
| Inv. | *1 37 | 1-7 | composition 1 | 2-4 | 25 | 72 | 0.50 | 0.50 | 53 |
| Inv. | *1 38 | 1-9 | composition 1 | 2-4 | 25 | 72 | 0.50 | 0.50 | 51 |
| Inv. | *1 39 | 1-10 | composition 1 | 2-4 | 25 | 72 | 0.50 | 0.50 | 51 |
| Inv. | *1 40 | 1-11 | composition 1 | 2-4 | 25 | 72 | 0.50 | 0.50 | 51 |
| Inv. | *1 41 | 1-12 | composition 1 | 2-4 | 25 | 72 | 0.50 | 0.50 | 50 |
| Inv. | *1 42 | 1-13 | composition 1 | 2-4 | 25 | 72 | 0.50 | 0.50 | 50 |
| Inv. | *1 43 | 1-14 | composition 1 | 2-4 | 25 | 72 | 0.50 | 0.50 | 50 |
| Inv. | *1 44 | 1-19 | composition 1 | 2-5 | 25 | 72 | 0.50 | 0.50 | 50 |
| Inv. | *1 45 | 1-20 | composition 1 | 2-5 | 25 | 72 | 0.50 | 0.50 | 50 |
| Inv. | *1 46 | 1-21 | composition 1 | 2-5 | 25 | 72 | 0.50 | 0.50 | 50 |

(continued)

| | Holographic recording medium No. | first substrate and first anti-reflection layer laminated substrate No. | composition for forming holographic recording layers No. | reflection layer laminated substrate No. | condition of heat-treatment | | Thickness of the recording layer Dh (mm) | Dh/(D1+D2) | mass ratios per unit area |
|---|---|---|---|---|---|---|---|---|---|
| | | | | | Temperature (°C) | Time (hr) | | | |
| Inv. | *1 | 1-22 | composition 1 | 2-5 | 25 | 72 | 0.50 | 0.50 | 50 |

*1: recording medium

<<Recording on the holographic recording media and its evaluation>>

(Recording on the holographic recording media and its evaluation 1)

One set of the above prepared holographic recording media was stored at a temperature of 23 °C and a relative humidity of 40% in a dark room for one week. (Normal storage) Another set of the above prepared holographic recording media was stored at a temperature of 40 °C and a relative humidity of 90% in a dark room for one week. (Wet storage) After the storage, a series of multiple holograms were written on the above sets of the holographic recording media according to the procedure disclosed in Specification of US Patent 5,719,691. Their sensitivities (recording energies) were measured and evaluated by the methods below. The result of measurement and evaluation are listed in Table 4.

(Measurement of sensitivities)

The method of sensitivity measurement and evaluation comprises the steps of producing digital patterns for hologram by a holograph, creator equipped with a Nd: YAG laser (532 nm),
holographically recording the digital patterns on a holographic recording medium which was stored under the normal condition at an energy of 0.1 to 30 mJ/cm$^2$,
placing the recorded holographic recording medium 20 cm under a 20-watt white fluorescent lamp for one hour,
applying a reference laser light of Nd: YAG laser (532 nm) to the recording medium,
reading the generated reproduction light by a CCD,
measuring the minimum exposure that reproduces preferable digital patterns as the sensitivity (S11), and
similarly measuring the minimum exposure, as the sensitivity (S12), that reproduces preferable digital patterns on a holographic recording medium which was stored under the high humidity condition.

Table 4

| | Holographic recording medium No. | mass ratios per unit area | S11 [mJ/cm$^2$] | S12 [mJ/cm$^2$] |
|---|---|---|---|---|
| Comp. | recording medium 1 | 100 | 5.8 | 6.3 |
| Comp. | recording medium 2 | 56 | 6.5 | 14.0 |
| Comp. | recording medium 3 | 56 | 10.5 | 18.0 |
| Comp. | recording medium 4 | 51 | 7.8 | 8.8 |
| Comp. | recording medium 5 | 100 | 2.1 | 2.5 |
| Inv. | recording medium 6 | 56 | 2.3 | 5.7 |
| Inv. | recording medium 7 | 56 | 2.8 | 5.4 |
| Inv. | recording medium 8 | 51 | 2.2 | 2.7 |
| Inv. | recording medium 9 | 100 | 1.8 | 2.1 |
| Inv. | recording medium 10 | 56 | 2.2 | 2.9 |
| Inv. | recording medium 11 | 56 | 2.3 | 2.9 |
| Inv. | recording medium 12 | 51 | 1.8 | 2.3 |
| Inv. | recording medium 13 | 51 | 1.9 | 2.3 |
| Inv. | recording medium 14 | 52 | 2.0 | 2.5 |
| Inv. | recording medium 15 | 51 | 1.9 | 2.3 |
| Inv. | recording medium 16 | 50 | 1.8 | 2.1 |
| Inv. | recording medium 17 | 50 | 1.8 | 2.1 |
| Inv. | recording medium 18 | 50 | 1.8 | 2.1 |
| Inv. | recording medium 19 | 55 | 2.6 | 3.1 |
| Inv. | recording medium 20 | 55 | 2.7 | 3.2 |
| Inv. | recording medium 21 | 54 | 2.6 | 3.2 |

(continued)

| | Holographic recording medium No. | mass ratios per unit area | S11 [mJ/cm²] | S12 [mJ/cm²] |
|---|---|---|---|---|
| Inv. | recording medium 22 | 55 | 2.6 | 3.2 |
| Inv. | recording medium 23 | 56 | 3.2 | 3.4 |
| Inv. | recording medium 24 | 51 | 3.0 | 3.2 |
| Inv. | recording medium 25 | 52 | 3.1 | 3.4 |
| Inv. | recording medium 26 | 50 | 3.2 | 3.3 |

From the above Table, it is apparent that the holographic recording media of this invention are lighter in weight than comparative examples and higher in sensitivity independently of the media storage condition.

(Recording on the holographic recording media and its evaluation 2)

Two kinds of test recording media were provided: One set of the holographic recording media that were stored at a temperature of 23 °C and a relative humidity of 40% in a dark room for one week (Normal storage) and another set of the holographic recording media that were stored at a temperature of 23 °C and a relative humidity of 0% in a dark room filled with oxygen gas for one week. (Oxygen-rich storage) These sets of recording media were recorded and evaluated in the method similar to the above method 1. The results of measurement and evaluation are listed in Table 5. In Table 5, S21 is the minimum exposure of the holographic recording media that were stored under the normal storage condition and S22 is the minimum exposure of the holographic recording media that were stored under the oxygen-rich storage condition.

Table 5

| | Holographic recording medium No. | mass ratios per unit area | S21 [mJ/cm²] | S22 [mJ/cm²] |
|---|---|---|---|---|
| Comp. | recording medium 1 | 100 | 5.8 | 6.2 |
| Comp. | recording medium 3 | 56 | 10.5 | 15.5 |
| Comp. | recording medium 4 | 51 | 7.8 | 8.4 |
| Comp. | recording medium 5 | 100 | 2.1 | 2.3 |
| Inv. | recording medium 12 | 51 | 1.8 | 2.2 |
| Inv. | recording medium 13 | 51 | 1.9 | 2.2 |
| Inv. | recording medium 16 | 50 | 1.8 | 2.0 |
| Inv. | recording medium 17 | 50 | 1.8 | 2.0 |
| Inv. | recording medium 18 | 50 | 1.8 | 2.0 |
| Inv. | recording medium 23 | 56 | 3.2 | 3.3 |
| Inv. | recording medium 24 | 51 | 3.0 | 3.1 |
| Inv. | recording medium 26 | 50 | 3.2 | 3.2 |

From the above Table, it is apparent that the holographic recording media of this invention are lighter in weight than comparative examples and higher in sensitivity independently of the media storage condition.

(Recording on the holographic recording media and its evaluation 3)

One set of the above prepared holographic recording media was stored at a temperature of 23 °C and a relative humidity of 40% in a dark room for one week. (Normal storage) Another set of the above prepared holographic recording media was stored at a temperature of 40 °C and a relative humidity of 90% in a dark room for one week. (Wet storage) After the storage, a series of multiple holograms were written on the above sets of the holographic recording media according to the procedure disclosed in Specification of Japanese Non-Examined Patent Publication 2002-123949. Their sensitivities (recording energies) were measured and evaluated by the methods below. The result of measurement and

evaluation are listed in Table 6.

(Measurement of sensitivities)

The method of sensitivity measurement and evaluation comprises the steps of producing digital patterns for hologram by a holograph creator equipped with a Nd: YAG laser (532 nm),
holographically recording the digital patterns on a holographic recording medium which was stored under the normal condition at an energy of 0.1 to 30 mJ/cm$^2$,
placing the recorded holographic recording medium 20 cm under a 20-watt white fluorescent lamp for one hour,
applying a reference laser light of Nd: YAG laser (532 nm) to the recording medium,
reading the generated reproduction light by a CCD,
measuring the minimum exposure that reproduces preferable digital patterns as the sensitivity (S31), and
similarly measuring the minimum exposure, as the sensitivity (S32), that reproduces preferable digital patterns on a holographic recording medium which was stored under the high humidity condition.

Table 6

| | Holographic recording medium No. | mass ratios per unit area | S31 [mJ/cm$^2$] | S32 [mJ/cm$^2$] |
|---|---|---|---|---|
| Comp. | recording medium 27 | 100 | 4.7 | 5.1 |
| Comp. | recording medium 28 | 56 | 5.5 | 10 |
| Comp. | recording medium 29 | 56 | 6.5 | 11 |
| Comp. | recording medium 30 | 51 | 6.0 | 7.5 |
| Comp. | recording medium 31 | 100 | 2.2 | 2.7 |
| Inv. | recording medium 32 | 56 | 2.4 | 2.9 |
| Inv. | recording medium 33 | 56 | 2.7 | 3.1 |
| Inv. | recording medium 34 | 51 | 2.3 | 2.8 |
| Inv. | recording medium 35 | 50 | 2.3 | 2.8 |
| Inv. | recording medium 36 | 53 | 1.8 | 2.2 |
| Inv. | recording medium 37 | 53 | 2.0 | 2.5 |
| Inv. | recording medium 38 | 51 | 1.7 | 1.9 |
| Inv. | recording medium 39 | 51 | 1.8 | 2.1 |
| Inv. | recording medium 40 | 51 | 1.7 | 2.0 |
| Inv. | recording medium 41 | 50 | 1.7 | 1.9 |
| Inv. | recording medium 42 | 50 | 1.7 | 1.9 |
| Inv. | recording medium 43 | 50 | 1.7 | 1.9 |
| Inv. | recording medium 44 | 50 | 2.9 | 3.1 |
| Inv. | recording medium 45 | 50 | 2.7 | 2.9 |
| Inv. | recording medium 46 | 50 | 2.8 | 2.9 |
| Inv. | recording medium 47 | 50 | 2.8 | 2.9 |

From the above Table, it is apparent that the holographic recording media of this invention are lighter in weight than comparative examples and higher in sensitivity independently of the media storage condition.

(Recording on the holographic recording media and its evaluation 4)

Two kinds of test recording media were provided: One set of the holographic recording media that were stored at a temperature of 23 °C and a relative humidity of 40% in a dark room for one week (Normal storage) and another set of the holographic recording media that were stored at a temperature of 23 °C and a relative humidity of 0% in a dark

room filled with oxygen gas for one week. (Oxygen-rich storage) These sets of recording media were recorded and evaluated in the method similar to the above method 3. The results of measurement and evaluation are listed in Table 7. In Table 7, S41 is the minimum exposure of the holographic recording media that were stored under the normal storage condition and S42 is the minimum exposure of the holographic recording media that were stored under the oxygen-rich storage condition.

Table 7

| | Holographic recording medium No. | mass ratios per unit area | S41 [mJ/cm$^2$] | S42 [mJ/cm$^2$] |
|---|---|---|---|---|
| Comp. | recording medium 27 | 100 | 4.7 | 5.1 |
| Comp. | recording medium 29 | 56 | 6.5 | 9.0 |
| Comp. | recording medium 30 | 51 | 6.0 | 6.5 |
| Comp. | recording medium 31 | 100 | 2.2 | 2.4 |
| Inv. | recording medium 33 | 56 | 2.7 | 2.9 |
| Inv. | recording medium 34 | 51 | 2.3 | 2.5 |
| Inv. | recording medium 35 | 50 | 2.3 | 2.4 |
| Inv. | recording medium 38 | 51 | 1.7 | 1.8 |
| Inv. | recording medium 41 | 50 | 1.7 | 1.7 |
| Inv. | recording medium 42 | 50 | 1.7 | 1.7 |
| Inv. | recording medium 43 | 50 | 1.7 | 1.7 |
| Inv. | recording medium 44 | 50 | 2.9 | 3.0 |
| Inv. | recording medium 45 | 50 | 2.7 | 2.8 |
| Inv. | recording medium 47 | 50 | 2.8 | 2.8 |

From the above Table, it is apparent that the holographic recording media of this invention are lighter in weight than comparative examples and higher in sensitivity independently of the media storage condition.

(Recording on the holographic recording media and its evaluation 4)

Two kinds of test recording media were provided: One set of the holographic recording media that were stored at a temperature of 23 °C and a relative humidity of 40% in a dark room for two weeks (Normal storage) and another set of the holographic recording media that were stored at a temperature of a temperature of 40°C and a relative humidity of 90% for one week and then at 23°C and a relative humidity of 0% in a dark room filled with oxygen gas for one week. (Wet and oxygen-rich storage) These sets of recording media were recorded and evaluated in the method similar to the above method 3. The results of measurement and evaluation are listed in Table 8. In Table 8, S51 is the minimum exposure of the holographic recording media that were stored under the normal storage condition and S52 is the minimum exposure of the holographic recording media that were stored under the wet oxygen-rich storage condition.

Table 8

| | Holographic recording medium No. | mass ratios per unit area | S51 [mJ/cm$^2$] | S52 [mJ/cm$^2$] |
|---|---|---|---|---|
| Comp. | recording medium 27 | 100 | 4.7 | 5.3 |
| Comp. | recording medium 29 | 56 | 6.5 | 12.0 |
| Comp. | recording medium 30 | 51 | 6.0 | 8.0 |
| Comp. | recording medium 31 | 100 | 2.2 | 2.7 |
| Inv. | recording medium 33 | 56 | 2.7 | 3.2 |
| Inv. | recording medium 34 | 51 | 2.3 | 2.9 |
| Inv. | recording medium 35 | 50 | 2.3 | 2.8 |

(continued)

| | Holographic recording medium No. | mass ratios per unit area | S51 [mJ/cm2] | S52 [mJ/cm2] |
|---|---|---|---|---|
| Inv. | recording medium 38 | 51 | 1.7 | 1.9 |
| Inv. | recording medium 41 | 50 | 1.7 | 1.9 |
| Inv. | recording medium 42 | 50 | 1.7 | 1.9 |
| Inv. | recording medium 43 | 50 | 1.7 | 1.9 |
| Inv. | recording medium 44 | 50 | 2.9 | 3.1 |
| Inv. | recording medium 45 | 50 | 2.7 | 2.9 |
| Inv. | recording medium 47 | 50 | 2.8 | 2.9 |

From the above Table, it is apparent that the holographic recording media of this invention are lighter in weight than comparative examples and higher in sensitivity independently of the media storage condition.

(Evaluation of the holographic information media)

The holographic information media were evaluated in the method comprising the steps of storing the holographic information media of Table 4 to Table 8 which store fixed information under the normal storage condition, evaluating reproduction of digital patterns by their optimum methods before and after the normal storage, and evaluating the ratios of reproductions of digital patterns in the methods below. The results of evaluation are listed in Table 9.

(Waterproof storage stability)

The holographic information media were kept in water for one week storage, dried at a temperature of 23 °C and a relative humidity of 50% for 12 hours and measured in terms of the ratios of reproductions of digital patterns.

Reproduction ratio (Es) = (Count of digital patterns after storage) / (Count of digital patterns before storage) x 100

(Waterproof storage stability)

The holographic information media were kept at a temperature of 40 °C and a relative humidity of 90% for two weeks, dried at a temperature of 23 °C and a relative humidity of 50% for 30 minutes, and measured in terms of the ratios of reproductions of digital patterns.

Reproduction ratio (Eh) = (Count of digital patterns after storage) / (Count of digital patterns before storage) x 100

Table 9

| | Holographic information medium No. | Holographic recording medium No. | mass ratios per unit area | Es | Eh |
|---|---|---|---|---|---|
| Comp. | information medium 1 | recording medium 1 | 100 | 100 | 6 |

(continued)

| | Holographic information medium No. | Holographic recording medium No. | mass ratios per unit area | Es | Eh |
|---|---|---|---|---|---|
| Comp. | information medium 2 | recording medium 3 | 56 | 60 | 16 |
| Comp. | information medium 3 | recording medium 4 | 51 | 100 | 8 |
| Comp. | information medium 4 | recording medium 5 | 100 | 100 | 2 |
| Inv. | information medium 5 | recording medium 12 | 51 | 100 | 2 |
| Inv. | information medium 6 | recording medium 13 | 51 | 100 | 2 |
| Inv. | information medium 7 | recording medium 16 | 50 | 100 | 2 |
| Inv. | information medium 8 | recording medium 17 | 50 | 100 | 2 |
| Inv. | information medium 9 | recording medium 18 | 50 | 100 | 2 |
| Inv. | information medium 10 | recording medium 23 | 56 | 100 | 3 |
| Inv. | information medium 11 | recording medium 24 | 51 | 100 | 3 |
| Inv. | information medium 12 | recording medium 26 | 50 | 100 | 3 |
| Comp. | information medium 13 | recording medium 27 | 100 | 100 | 5.1 |
| Comp. | information medium 14 | recording medium 29 | 56 | 65 | 85 |
| Comp. | information medium 15 | recording medium 31 | 100 | 100 | 100 |
| Inv. | information medium 16 | recording medium 34 | 51 | 100 | 100 |
| Inv. | information medium 17 | recording medium 35 | 50 | 100 | 100 |
| Inv. | information medium 18 | recording medium 38 | 51 | 100 | 100 |
| Inv. | information medium 19 | recording medium 41 | 50 | 100 | 100 |
| Inv. | information medium 20 | recording medium 42 | 50 | 100 | 100 |
| Inv. | information medium 21 | recording medium 43 | 50 | 100 | 100 |
| Inv. | information medium 22 | recording medium 45 | 50 | 100 | 100 |
| Inv. | information medium 23 | recording medium 47 | 50 | 100 | 100 |
| Inv. | information medium 24 | recording medium 38 | 51 | 100 | 100 |
| Inv. | information medium 25 | recording medium 41 | 50 | 100 | 100 |
| Inv. | information medium 26 | recording medium 42 | 50 | 100 | 100 |
| Inv. | information medium 27 | recording medium 43 | 50 | 100 | 100 |
| Inv. | information medium 28 | recording medium 45 | 50 | 100 | 100 |
| Inv. | information medium 29 | recording medium 47 | 50 | 100 | 100 |

From the above Table, it is apparent that the holographic recording media of this invention are lighter in weight than comparative examples and less in error generation independently of the media storage condition.

## Claims

**1.** A holographic recording medium comprising:

an anti-reflection layer;
an first substrate;
a holographic recording layer containing a binder forming compound, a photopolymerizable compound which has a functional group being capable of photopolymerization and a photopolymerization initiator which can

initiate a polymerization reaction of the photopolymerizable compound; and
a second substrate, in that order,
wherein at least one of the first substrate and the second substrate is a plastic substrate having a light transmittance of more than 90% measured according to ASTM D1003 at a thickness of 3 mm.

**2.** The holographic recording medium of claim 1, wherein a refractive index of a binder formed by the binder forming compound is less than a refractive index of a polymerized compound formed by polymerization of the photopolymerizable compound.

**3.** The holographic recording medium of claim 1, wherein both the first substrate and the second substrate are plastic substrates.

**4.** The holographic recording medium of claim 1, wherein the plastic substrate comprises at least a compound selected from the group consisting of: a resin which has a cyclic olefin as a monomeric unit; a resin which has 1,1- bis (four hydroxyphenyls) cyclohexane as a monomeric unit; a resin which has 1,1- bis (4- hydroxyphenyl) -3,3,5- trimethyl cyclohexane as a monomeric unit; and a resin represented with the below general formula (1).

Formula (1)

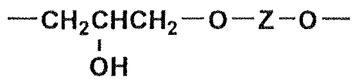

(In the general formula (1), Z represents a divalent linkage group.)

**5.** The holographic recording medium of claim 1, wherein the plastic substrate has a resin which has a cyclic olefin as a monomeric unit.

**6.** The holographic recording medium of claim 1, wherein the plastic substrate has a resin which has a glass transition temperature of 100°C to 100 °C.

**7.** The holographic recording medium of claim 1, wherein the plastic substrate has a resin which has an oxygen permeability specified by ASTM D3985 of less than 1000 $cm^3 \cdot mm/(m^2 \cdot d \cdot MPa)$.

**8.** The holographic recording medium of claim 1, wherein the plastic substrate has a resin which has a water absorption specified by ASTM D570 of less than 0.05%.

**9.** The holographic recording medium of claim 1, wherein at least one surface of the second substrate is covered with a reflection layer having a reflectance of more than 80%.

**10.** The holographic recording medium of claim 1, wherein the holographic recording medium satisfies the following relationship:

$$0.15 \leq Dh/(D1 + D2) \leq 2.0,$$

wherein D1 is the thickness of the first substrate, D2 is the thickness of the second substrate, and Dh is the thickness of the holographic recording layer.

**11.** The holographic recording medium of claim 10, wherein the holographic recording layer has the Dh of 200 μm to 2.0 mm.

**12.** The holographic recording medium of claim 10, wherein the holographic recording medium satisfies a relationship of $D1 \leq D2$.

**13.** The holographic recording medium of claim 1, wherein the holographic recording medium is a disk-shaped medium.

**14.** The holographic recording medium of claim 1, wherein the holographic recording medium is a card-shaped medium.

**15.** A holographic recording method for recording information on the holographic recording medium of claim 1, comprising:

reacting the binder forming compound for forming a binder; holographic exposing a surface of the anti-reflection layer of the holographic recording medium based on the information for generating activated species by activating the photopolymerization initiator; and
diffusion polymerizing the photopolymerizable compound by the activated species in the holographic recording layer.

**16.** The holographic recording method of claim 15, further comprising:

stabilizing the information by heating or photoirradiating the holographic recording medium.

**17.** A holographic information medium comprising:

an anti-reflection layer;
an first substrate;
a holographic information recording layer containing a binder area containing the binder as major component formed by reacting a binder forming compound and a photopolymerized area containing a photopolymerized compound a major component formed by photopolymerizing a compound which has a functional group being capable of photopolymerization, and a refractive index of the binder area is lower than a refractive index of the photopolymerized area;
a second substrate, in that order,
wherein at least one of the first substrate and the second substrate is a plastic substrate having a light transmittance of more than 90% measured according to ASTM D1003 at a thickness of 3 mm.

**18.** The holographic information medium of claim 17, wherein at least one surface of the second substrate is covered with a reflection layer having a reflectance of more than 80%.

FIG. 1 ( a )

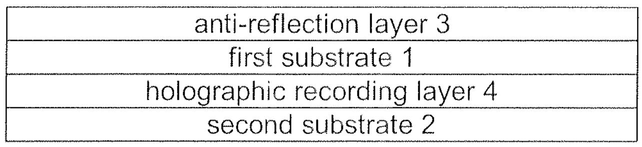


FIG. 1 ( b )

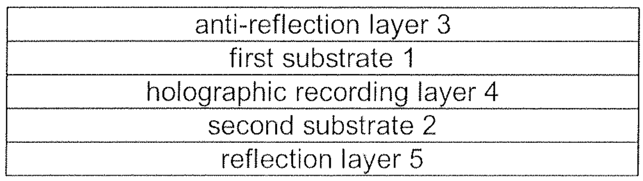


FIG. 1 ( c )

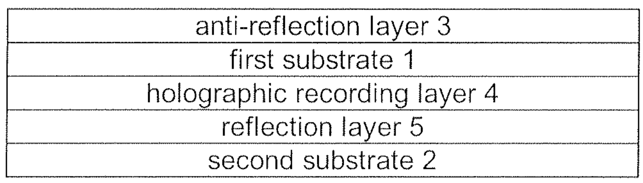

## INTERNATIONAL SEARCH REPORT

International application No.
PCT/JP2005/008052

A. CLASSIFICATION OF SUBJECT MATTER
Int.Cl[7] G03H1/02, G03H1/04, G11B7/0065

According to International Patent Classification (IPC) or to both national classification and IPC

B. FIELDS SEARCHED

Minimum documentation searched (classification system followed by classification symbols)
Int.Cl[7] G03H1/02, G03H1/04, G11B7/0065

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2004-126041 A (Memory-Tech Corp. et al.), 22 April, 2004 (22.04.04), Par. Nos. [0016] to [0022]; Fig. 2 (Family: none) | 1-18 |
| Y | JP 2004-126040 A (Memory-Tech Corp. et al.), 22 April, 2004 (22.04.04), Par. Nos. [0018] to [0021]; Fig. 2 (Family: none) | 1-18 |
| Y | JP 2001-006215 A (Mitsubishi Chemical Corp.), 12 January, 2001 (12.01.01), Par. Nos. [0009], [0010]; Figs. 1, 2 (Family: none) | 1-18 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 May, 2005 (25.05.05) | 14 June, 2005 (14.06.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

INTERNATIONAL SEARCH REPORT

International application No.
PCT/JP2005/008052

C (Continuation). DOCUMENTS CONSIDERED TO BE RELEVANT

| Category* | Citation of document, with indication, where appropriate, of the relevant passages | Relevant to claim No. |
|---|---|---|
| Y | JP 09-091757 A (Sanyo Electric Co., Ltd.), 04 April, 1997 (04.04.97), Par. Nos. [0011], [0013]; Figs. 2, 4 (Family: none) | 1-18 |
| Y | JP 2002-318319 A (Mitsubishi Gas Chemical Co., Inc.), 31 October, 2002 (31.10.02), Claims 1 to 3 & US 2002/192601 A1 | 1-18 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 5719691 A
- JP 2002123949 A
- GB 9929953 A
- JP 10340479 A
- US 4942112 A
- US 5759721 A
- US 6103454 A
- US 6348983 B
- US 6611365 B
- JP 5025220 A
- JP 5247324 A
- JP 5279554 A
- JP 6080864 A
- JP 6107735 A
- JP 6107736 A
- JP 6136035 A
- JP 6136057 A
- JP 7041550 A
- JP 7062068 A
- JP 7324108 A
- JP 9263627 A
- JP 10152549 A
- JP 2000219725 A
- JP 2000212226 A
- JP 5140232 A
- JP 6128557 A
- JP 6228234 A
- JP 8109222 A
- JP 10245420 A
- JP 5097978 A
- JP 6206985 A
- JP 6279656 A
- JP 7062028 A
- JP 7173085 A
- JP 7179730 A
- JP 7228673 A
- JP 9221577 A
- JP 9296028 A
- JP 9316179 A
- JP 9324082 A
- JP 9326512 A
- JP 2088638 A
- JP 7027902 A
- JP 2001123264 A
- JP 2001264509 A
- JP 5142401 A
- JP 5249303 A
- JP 6003504 A
- JP 6331803 A
- JP 7035902 A
- JP 7253501 A
- JP 11311702 A
- US 5838467 A
- US 6700686 B
- JP 2003178456 A
- JP 2003228875 A
- JP 2003331464 A
- JP 2004126038 A
- JP 2004126040 A
- JP 2004126041 A
- JP 2004127379 A
- US 6625100 B
- US 20040042375 A
- US 20040067419 A
- WO 9957719 A
- JP 58037003 A
- JP 63223002 A
- JP 56152833 A
- JP 63008365 A
- JP 63008366 A
- JP 1083060 A
- JP 1290658 A
- JP 2001470 A
- JP 2196812 A
- JP 2232253 A
- JP 3017101 A
- JP 3047164 A
- JP 3048654 A
- JP 3145459 A
- JP 3200761 A
- JP 3237107 A
- JP 4001177 A
- JP 4210673 A
- JP 8188569 A
- JP 8188570 A
- JP 11029609 A
- JP 11255739 A
- JP 2001055374 A
- JP 6301322 A
- JP 2000344716 A
- JP 2003029604 A
- US 5027436 A
- US 5096790 A
- US 5147758 A
- US 5204467 A
- US 5256520 A
- US 6011180 A
- EP 255486 A

- EP 256981 A
- EP 277915 A
- EP 318893 A
- EP 401165 A
- EP 565488 A
- JP 2236553 A
- JP 5046061 A
- JP 5216227 A
- JP 5247110 A
- JP 5257279 A
- JP 6175554 A
- JP 6175562 A
- JP 6175563 A
- JP 6175566 A
- JP 6186899 A
- JP 6195015 A
- JP 6202540 A
- JP 6202541 A
- JP 6202543 A
- JP 6202544 A
- JP 6202548 A
- JP 6324615 A
- JP 6329654 A
- JP 7013473 A
- JP 7028379 A
- JP 7084502 A
- JP 7084503 A
- JP 7181876 A
- JP 9106069 A
- JP 9309907 A
- JP 2002060429 A
- JP 2002062786 A
- JP 2002244535 A
- JP 2002296764 A
- US 6163391 A
- US 6414296 B
- US 2002136143 A
- JP 9305978 A
- JP 10124872 A
- JP 11219540 A
- JP 2000098862 A
- JP 2000298837 A
- JP 2001023169 A
- JP 2002083431 A
- JP 2002123948 A
- JP 2003043904 A
- WO 0205270 A
- WO 0275727 A

**Non-patent literature cited in the description**

- **HANS J. COUFAL.** Holographic Data Storage (Springer Series in Optical Sciences. Springer-Verlag GmbH & Co, August 2000, vol. 76